(19) Europäisches Patentamt / European Patent Office / Office européen des brevets

(11) **EP 2 407 575 B1**

(12) **EUROPEAN PATENT SPECIFICATION**

(45) Date of publication and mention of the grant of the patent:
**12.08.2015 Bulletin 2015/33**

(21) Application number: **10750864.0**

(22) Date of filing: **10.03.2010**

(51) Int Cl.:
*C23C 14/08* (2006.01)  *C23C 14/34* (2006.01)
*C23C 14/58* (2006.01)  *H01B 5/14* (2006.01)
*H01B 13/00* (2006.01)  *H01L 31/04* (2014.01)
*H01B 1/02* (2006.01)  *H01B 1/08* (2006.01)
*H01L 31/0236* (2006.01)  *C04B 35/453* (2006.01)
*C23C 14/00* (2006.01)  *H01L 31/18* (2006.01)
*H01L 31/0224* (2006.01)

(86) International application number:
**PCT/JP2010/054004**

(87) International publication number:
**WO 2010/104111 (16.09.2010 Gazette 2010/37)**

(54) **TRANSPARENT CONDUCTIVE FILM AND TRANSPARENT CONDUCTIVE FILM LAMINATE, PROCESSES FOR PRODUCTION OF SAME, AND SILICON THIN FILM SOLAR CELL**

TRANSPARENTER LEITFÄHIGER FILM UND LAMINAT FÜR EINEN TRANSPARENTEN LEITFÄHIGEN FILM, VERFAHREN ZU IHRER HERSTELLUNG UND SILICIUMDÜNNSCHICHT-SOLARZELLE

FILM CONDUCTEUR TRANSPARENT ET STRATIFIÉ À FILM CONDUCTEUR TRANSPARENT, PROCÉDÉS PERMETTANT DE LES FABRIQUER ET CELLULE SOLAIRE À FILM MINCE DE SILICIUM

(84) Designated Contracting States:
**AT BE BG CH CY CZ DE DK EE ES FI FR GB GR HR HU IE IS IT LI LT LU LV MC MK MT NL NO PL PT RO SE SI SK SM TR**

(30) Priority: **13.03.2009 JP 2009061045**

(43) Date of publication of application:
**18.01.2012 Bulletin 2012/03**

(73) Proprietor: **Sumitomo Metal Mining Co., Ltd.**
**Tokyo 105-8716 (JP)**

(72) Inventors:
• **ABE, Yoshiyuki**
**Ichikawa-shi**
**Chiba 272-8588 (JP)**
• **NAKAYAMA, Tokuyuki**
**Ichikawa-shi**
**Chiba 272-8588 (JP)**

(74) Representative: **Müller-Boré & Partner**
**Patentanwälte PartG mbB**
**Friedenheimer Brücke 21**
**80639 München (DE)**

(56) References cited:
EP-A1- 1 422 312     WO-A1-2008/062685
WO-A1-2008/062685   WO-A1-2009/008297
WO-A1-2009/084527   WO-A1-2010/004811
JP-A- 2002 222 972   JP-A- 2002 222 972
JP-A- 2002 260 448   JP-A- 2003 115 599
JP-A- 2003 115 599   JP-A- 2004 311 968
JP-A- 2005 347 490   JP-A- 2007 329 109
JP-A- 2009 010 108

• J.F. CHANG ET AL: "Effects of post-annealing on the structure and properties of Al-doped zinc oxide films", APPLIED SURFACE SCIENCE, vol. 183, no. 1-2, 1 November 2001 (2001-11-01), pages 18-25, XP55033740, ISSN: 0169-4332, DOI: 10.1016/S0169-4332(01)00541-4

EP 2 407 575 B1

(Cont. next page)

- **TADATSUGU MINAMI ET AL: "SUBSTRATE TEMPERATURE DEPENDENCE OF TRANSPARENT CONDUCTING AL-DOPED ZNO THIN FILMS PREPARED BY MAGNETRON SPUTTERING", JAPANESE JOURNAL OF APPLIED PHYSICS, JAPAN SOCIETY OF APPLIED PHYSICS, JP, vol. 31, no. 3A, 1 March 1992 (1992-03-01) , pages L257-L260, XP000323108, ISSN: 0021-4922, DOI: 10.1143/JJAP.31.L257**
- **MULLER J ET AL: "Upscaling of texture-etched zinc oxide substrates for silicon thin film solar cells", THIN SOLID FILMS, ELSEVIER-SEQUOIA S.A. LAUSANNE, CH, vol. 392, no. 2, 30 July 2001 (2001-07-30) , pages 327-333, XP004250761, ISSN: 0040-6090, DOI: 10.1016/S0040-6090(01) 01052-5**

Remarks:
    The file contains technical information submitted after the application was filed and not included in this specification

Remarks:

**Description**

The present invention relates to a transparent conductive film and a transparent conductive film laminated body and a production method of same, and a silicon-based thin film solar cell, and in more detail, relates to a transparent conductive film, useful in producing a highly efficient silicon-based thin film solar cell, superior in hydrogen reduction resistance and superior in optical confinement effect; a transparent conductive film laminated body using the same; a production method of same; and a silicon-based thin film solar cell using this transparent conductive film or the transparent conductive film laminated body, as an electrode.

A transparent conductive film having high conductivity and high transmittance in a visible light region has been utilized in an electrode or the like, for a solar cell or a liquid crystal display element, and other various light receiving elements, as well as a heat ray reflection film for an automotive window or construction use, an antistatic film, and a transparent heat generator for various anti-fogging for a refrigerator showcase and the like.

As the transparent conductive film, there has been known a thin film based on tin oxide ($SnO_2$)-type, zinc oxide (ZnO)-type, indium oxide ($In_2O_3$)-type. As the tin oxide-type, one containing antimony as a dopant (ATO), or one containing fluorine as a dopant (FTO) has been utilized. As the zinc oxide-type, one containing aluminum as a dopant (AZO), or one containing gallium as a dopant (GZO) has been utilized. The transparent conductive film most widely used industrially is the indium oxide-type, and among them, indium oxide containing tin as a dopant is called an ITO (Indium-Tin-Oxide) film, and has been utilized widely, because, in particular, a film with low resistance can be obtained easily.

In recent years, problems of global environment caused by increase in carbon dioxide, and price hike of fossil fuel have been closed up, and a thin film solar cell producible at relatively low cost has attracted the attention. The thin film solar cell generally contains a transparent conductive film sequentially laminated on a translucent substrate, one or more semiconductor thin film photoelectric converting units, and a back surface electrode. Because a silicon material is abundant in resource, the silicon-based thin film solar cell using a silicon-based thin film as the photoelectric converting unit (a light absorbing layer) was practically used with extraordinary speed, among the thin film solar cells, and research and development thereof has increasingly been progressed actively.

And, kinds of the silicon-based thin film solar cells have been diversified, and other than amorphous thin film solar cells using an amorphous thin film such as amorphous silicon as a conventional light absorbing layer, a micro crystalline thin film solar cell using a micro crystalline thin film in which fine crystalline silicon is present together in amorphous silicon, or a crystalline thin film solar cell using a crystalline thin film composed of crystalline silicon, has been developed, and also a hybrid thin film solar cell obtained by laminating these has also been practically used.

Here, the photoelectric converting unit or the thin film solar cell in which the photoelectric converting layer occupying a major part thereof is amorphous is called an amorphous unit or an amorphous thin film solar cell, while one in which the photoelectric converting layer is crystalline is called a crystalline unit or a crystalline thin film solar cell, and one in which the photoelectric converting layer is micro crystalline is called a micro crystalline unit or a micro crystalline thin film solar cell, irrespective of whether a p-type and n-type conductive-type semiconductor layer contained therein is amorphous, crystalline or micro crystalline.

It should be noted that, the transparent conductive film has been used as a surface transparent electrode of the thin film solar cell, and to efficiently confine light injected from the translucent substrate side into the photoelectric conversion unit, many fine irregularities are usually formed at the surface thereof.

As an index representing degree of the irregularity of this transparent conductive film, there is haze ratio. This corresponds to one obtained by dividing scattering components, whose optical pass is bent, with total components, among transmitting light, when light of a specific light source was injected to the translucent substrate with the transparent conductive film, and is measured using usually a C light source containing visible light. Generally, the higher elevation difference of the irregularity is made, or the larger space between the concave part and the convex part of the irregularity becomes, the haze ratio becomes the higher, and the light injected into the photoelectric conversion unit is confined efficiently, that is, what is called optical confinement effect is superior.

Irrespective of whether the thin film solar cell is one having amorphous silicon, crystalline silicon or micro crystalline silicon as a single layer of a light absorption layer, or the above-described hybrid-type one, high short circuit current density (Jsc) can be attained, and the thin film solar cell with high conversion efficiency can be produced, as long as sufficient optical confinement can be performed by increasing the haze ratio of the transparent conductive film.

From the above object, as the transparent conductive film having high degree of the irregularity and high haze ratio, a metal oxide material containing tin oxide as a major component, which is produced by a thermal CVD method, has been known, and it has been utilized generally as a transparent electrode of the thin film solar cell.

A conductive-type semiconductor layer formed at the surface of the transparent conductive film is generally produced by a plasma CVD method, in gas atmosphere containing hydrogen. Raising formation temperature to make micro crystal contained in the conductive-type semiconductor layer results in promoting reduction of a metal oxide with existing hydrogen, and in the case of the transparent conductive film having tin oxide as a major component, loss of transparency caused by reduction with hydrogen is observed. Use of such a transparent conductive film with inferior transparency cannot attain the thin film solar cell with high conversion efficiency.

As a method for preventing reduction caused by hydrogen of the transparent conductive film having tin oxide as a major component, a method for forming thinly a zinc oxide film superior in reduction resistance, by a sputtering method, on the transparent conductive film composed of tin oxide with high degree of the irregularity formed by the thermal CVD method, has been proposed (NON-PATENT LITERATURE 1). There has been disclosed that transparency of the transparent conductive film can be maintained high by taking the above structure, because zinc oxide has strong bonding between zinc and oxygen and is superior in hydrogen reduction resistance.

However, because film formation should be performed by combining two kinds of methods, to obtain the transparent conductive film having the above structure, it increases cost and thus is not practical. In addition, as for a method for producing all of a laminated film of the tin oxide-based transparent conductive film and the zinc oxide-based transparent conductive film, by the sputtering method, because of reasons that the tin oxide-based transparent conductive film with high transparency cannot be produced by the sputtering method and the like, it is said not attainable.

On the other hand, a method for obtaining the transparent conductive film having zinc oxide as a major component, surface irregularity and high haze ratio, by the sputtering method, has been proposed (NON-PATENT LITERATURE 2). In this method, sputtering film formation is performed using a sintered body target of zinc oxide added with 2% by weight of $Al_2O_3$, under high gas pressure of 3 to 12 Pa, at a substrate temperature of 200 to 400°C. However, film formation is performed by charging power of DC 80 W to a target with a size of 6 inch $\Phi$, therefore input power density to the target is as extremely slow as 0.442 W/cm$^2$. Therefore, film formation speed is as extremely low as 14 to 35 nm/min, and thus it is not practicable industrially.

In addition, a method for producing the transparent conductive film with high haze ratio by obtaining the transparent conductive film having zinc oxide as a major component, and small surface irregularity, prepared by a conventional sputtering method, and then by acid etching the surface of the film to make surface roughening, has been proposed (NON-PATENT LITERATURE 3). However, this method has problems of complicated process, high production cost and the like, because after producing a film by the sputtering method, which is a vacuum process, in a dry-type step, it requires acid etching in atmosphere, drying and forming a semiconductor layer by the CVD method of a dry-type step again.

As for AZO containing aluminum as a dopant, among materials of the zinc oxide-based transparent conductive film, there has been proposed a method for producing an AZO transparent conductive film with orientation to a C axis, by a direct current magnetron sputtering method, using a target having zinc oxide as a major component and mixed with aluminum oxide (refer to PATENT LITERATURE 1). In this case, when film formation is performed by direct current sputtering, under increased power density to be input to the target, to perform film formation in high speed, generation of arcing (abnormal discharge) happens frequently. Generation of arcing in a production step of a film formation line may generate film defect, or may not provide a film with predetermined thickness, and thus makes impossible stable production of a high quality transparent conductive film.

To overcome this problem, the present applicants have proposed a sputter target with reduced abnormal discharge by using zinc oxide as a major component mixed with gallium oxide, as well as adding a third element (Ti, Ge, Al, Mg, In, Sn) (refer to PATENT LITERATURE 2). Here, a GZO sintered body containing gallium as a dopant has a ZnO phase, as a major constituent phase of the structure, in which Ga and 2% by weight of at least one kind selected from the group consisting of Ti, Ge, Al, Mg, In and Sn are made as a solid solution, and other constituent phases are a ZnO phase without a solid solution with at least one kind of the above elements, or an intermediate compound phase represented by $ZnGa_2O_4$ (spinel phase). In such a GZO target added with the third element such as Al, although abnormal discharge as described in PATENT LITERATURE 1 can be reduced, it was impossible to completely eliminate it. In a continuous line of film formation, even once generation of abnormal discharge results in a defect product at that film formation time and influences production yield.

To solve these problems, the present applicants have proposed an oxide sintered body for a target, which hardly generates particles even in performing continuous film formation for a long period of time using a sputtering apparatus, and never generates abnormal discharge even under inputting of high direct current power, by optimization of content of aluminum and gallium in the oxide sintered body having zinc oxide as a major component and still more containing aluminum and gallium as addition elements, as well as by optimum control of kind and composition of crystalline phases, in particular, composition of the spinel phase generating during firing (refer to PATENT LITERATURE 3).

Using this, the higher quality transparent conductive film with lower resistance and higher transmittance as compared with conventional ones can be formed, therefore it is applicable to produce a solar cell with high conversion efficiency. However, in recent years, a solar cell with further higher conversion efficiency has been required, and high quality transparent conductive film which can be used for such a purpose has been required.

PATENT LITERATURE 1: 62-122011

PATENT LITERATURE 2: 10-306367

PATENT LITERATURE 3: 2008-110911

NON-PATENT LITERATURE 1: K. Sato et al., "Hydrogen Plasma Treatment of ZnO-Coated TCO Films", Proc. of 23th IEEE Photovoltaic Specialists Conference, Louisville, 1993, pp.855-859.
NON-PATENT LITERATURE 2: T. Minami, et. al., "Large-Area Milkey Transparent Conducting Al-Doped ZnO Films Prepared by Magnetron Sputtering", Japanese Journal of Applied Physics, [31] (1992), pp.L1106-1109.
NON-PATENT LITERATURE 3: J. Muller, et. al., Thin Solid Films, 392 (2001), p.327.

WO 2008/062685 A1 describes a substrate provided with a transparent conductive film for a photoelectric conversion device, comprising a transparent insulating substrate and a transparent electrode layer containing at least zinc oxide deposited on the transparent insulating substrate.

JP 2003-115599 A discloses a solar battery, wherein a first transparent conductive film, a IV group semiconductor conductive layer, a second transparent conductive layer, and an electrode are sequentially laminated, wherein the first transparent conductive film has an uneven face on its surface and is made of zinc oxide or a material of zinc oxide added with one or two kinds of elements from among aluminum, boron, gallium, iridium, yttrium and silicon.

JP 2002-222972 A describes a laminated solar battery comprising an intermediate layer made of a transparent conductive film provided between photoelectric conversion layers.

J. F. Chang et al., Applied Surface Science 183 (2001), 18-25, describe a study on effects of post-annealing on the structure and properties of Al-doped zinc oxide films.

WO 2009/084527 A1 describes a method for manufacturing a photovoltaic cell that is provided with an upper electrode that is arranged on the light incoming side and functions as a power extraction electrode, the method comprising the step of forming the upper electrode on a substrate by sputtering using a target that contains a zinc oxide-based material, wherein in the step of forming the upper electrode, the sputtering is performed in an atmosphere that contains two or three selected from a group consisting of hydrogen gas, oxygen gas, and water vapor.

T. Minami et al. , Japanese Journal of Applied Physics 1992 (31), L257-L260, describe a study on the substrate temperature dependence of transparent conducting Al-doped ZnO thin films prepared by magnetron sputtering.

J. Muller et al., Thin Solid Films 392 (2001), 327-333, describe a study on the upscaling of texture-etched zinc oxide substrates for silicon thin film solar cells.

In view of the above circumstance, it is an object of the present invention to provide a transparent conductive film, useful in producing a highly efficient silicon-based thin film solar cell, superior in hydrogen reduction resistance and superior in optical confinement effect, a transparent conductive film laminated body using the same, a production method therefor, and a silicon-based thin film solar cell using this transparent conductive film or the transparent conductive film laminated body, as an electrode.

The present inventors have intensively studied various transparent conductive film materials as the transparent conductive film to be used as a surface transparent electrode of a thin film solar cell, to solve such conventional technical problems, and have discovered that the zinc oxide-based transparent conductive film consisting of zinc oxide as a major component and at least one or more kinds of added metal elements selected from aluminum and gallium, in which content of aluminum [A1] and content of gallium [Ga] are within a specific range, and having a surface roughness (Ra) of 35.0 nm to 70 nm, and a surface resistance of more than 0 $\Omega/\square$ and equal to or lower than 65$\Omega/\square$ is superior in hydrogen reduction resistance and also superior in optical confinement effect. In addition, we have discovered that by forming this zinc oxide-based transparent conductive film on an indium oxide-based transparent conductive film, the transparent conductive film can be produced in high speed by the sputtering method only, and that the transparent conductive film having superior hydrogen reduction resistance, surface irregularity, high haze ratio, as well as high conductivity can be obtained, and have thus completed the present invention.

That is, according to a first aspect of the present invention, there is provided a transparent conductive film characterized by consisting of zinc oxide as a major component and at least one or more kinds of added metal elements selected from aluminum and gallium, whose content being within a range shown by the following expression (1), and having a surface roughness (Ra) of 35.0 nm to 70 nm, and a surface resistance of more than 0 $\Omega/\square$ and equal to or lower than 65$\Omega/\square$

$$-[A1]+0.30 \leq [Ga] \leq -2.68 \times [A1]+1.74 \quad --- \quad (1)$$

(wherein [Al] represents aluminum content expressed as atomic ratio (%) of Al/(Zn+Al); while [Ga] represents gallium content expressed as atomic ratio (%) of Ga/(Zn+Ga)), wherein said transparent conductive film is obtainable by a sputtering method, using an oxide sintered body target consisting of zinc oxide as a major component and at least one or more kinds of added metal elements selected from aluminum and gallium, wherein the film formation is performed in high speed, by setting a direct current input power density of equal to or higher than 1. 66 W/cm$^2$ to the aforesaid oxide sintered body target, under condition of a sputtering gas pressure of 2.0 to 15.0 Pa, and a substrate temperature of 200 to 500 °C.

In addition, according to a second aspect of the present invention, there is provided the transparent conductive film in the first aspect, characterized in that the haze ratio is equal to or higher than 8%.

In addition, according to a third aspect of the present invention, there is provided the transparent conductive film in the first aspect or the second aspect, characterized in that the haze ratio is equal to or higher than 10%.

In addition, according to a fourth aspect of the present invention, there is provided the transparent conductive film in any one of the first to the third aspects, characterized in that the haze ratio is equal to or higher than 16%.

In addition, according to a fifth aspect of the present invention, there is provided the transparent conductive film in the first aspect, characterized in that the surface resistance is equal to or lower than 20 Ω/□.

Still more, according to a sixth aspect of the present invention, there is provided the transparent conductive film in the first or fifth aspect, characterized in that the surface resistance is equal to or lower than 15 Ω/□.

On the other hand, according to a seventh aspect of the present invention, there is provided a method for producing the transparent conductive film in any one of the first to the sixth aspects, for forming a zinc oxide-based transparent conductive film (II) on a substrate, by a sputtering method, using an oxide sintered body target consisting of zinc oxide as a major component and at least one or more kinds of added metal elements selected from aluminum and gallium, characterized by performing film formation in high speed, by setting a direct current input power density of equal to or higher than 1.66 W/cm$^2$ to the aforesaid oxide sintered body target, under condition of a sputtering gas pressure of 2.0 to 15.0 Pa, and a substrate temperature of 200 to 500°C.

In addition, according to an eighth aspect of the present invention, there is provided a transparent conductive film laminated body, **characterized in that** the zinc oxide-based transparent conductive film (II) in any one of the first to the sixth aspects was formed on an indium oxide-based transparent conductive film (I) formed on the substrate.

Still more, according to a ninth aspect of the present invention, there is provided the transparent conductive film laminated body in the eighth aspect, **characterized in that** the transparent conductive film (II) is a crystalline film comprising a hexagonal crystalline phase.

In addition, according to a tenth aspect of the present invention, there is provided the transparent conductive film laminated body in the ninth aspect, **characterized in that** the hexagonal crystalline phase has approximately c-axis orientation, and a c-axis inclination angle is equal to or smaller than 10 degree, relative to a vertical direction of a substrate surface.

In addition, according to an eleventh aspect of the present invention, there is provided the transparent conductive film laminated body in the eighth aspect, **characterized in that** the indium oxide-based transparent conductive film (I) is a crystalline film consisting of indium oxide as a major component and at least one or more kinds of metal elements selected from Sn, Ti, W, Mo, and Zr.

In addition, according to a twelfth aspect of the present invention, there is provided the transparent conductive film laminated body in the eighth or eleventh aspect, **characterized in that** the indium oxide-based transparent conductive film (I) consists of indium oxide as a major component and Sn, whose content ratio is equal to or lower than 15% by atom, as atomic ratio of Sn/(In+Sn).

In addition, according to a thirteenth aspect of the present invention, there is provided the transparent conductive film laminated body in the eighth or eleventh aspect, **characterized in that** the indium oxide-based transparent conductive film (I) consists of indium oxide as a major component and Ti, whose content ratio is equal to or lower than 5.5% by atom, as atomic ratio of Ti/(In+Ti).

In addition, according to a fourteenth aspect of the present invention, there is provided the transparent conductive film laminated body in the eighth or eleventh aspect, **characterized in that** the indium oxide-based transparent conductive film (I) consists of indium oxide as a major component and W, whose content ratio is equal to or lower than 4.3% by atom, as atomic ratio of W/(In+W).

In addition, according to an fifteenth aspect of the present invention, there is provided the transparent conductive film laminated body in the eighth or eleventh aspect, **characterized in that** the indium oxide-based transparent conductive film (I) consists of indium oxide as a major component and Zr, whose content ratio is equal to or lower than 6.5% by atom, as atomic ratio of Zr/(In+Zr).

In addition, according to a sixteenth aspect of the present invention, there is provided the transparent conductive film laminated body in the eighth or eleventh aspect, **characterized in that** the indium oxide-based transparent conductive film (I) consists of indium oxide as a major component and Mo, whose content ratio is equal to or lower than 6.7% by atom, as atomic ratio of Mo/(In+Mo).

In addition, according to a seventeenth aspect of the present invention, there is provided the transparent conductive film laminated body in any one of the eighth to sixteenth aspects, **characterized in that** the surface resistance is equal to or lower than 20 Ω/□.

Still more, according to an eighteenth aspect of the present invention, there is provided the transparent conductive film laminated body in any one of the eighth to seventeenth aspects, **characterized in that** the haze ratio is equal to or higher than 12%.

On the other hand, according to a nineteenth aspect of the present invention, there is provided a method for producing the transparent conductive film laminated body in any one of the eighth to eighteenth aspects, characterized by firstly forming a crystalline film of the indium oxide-based transparent conductive film (I) on a substrate, by a sputtering method, using an oxide sintered body target consisting of indium oxide as a major component containing at least one or more kinds of metal elements selected from Sn, Ti, W, Mo, and Zr, and then forming the zinc oxide-based transparent conductive film (II) on the indium oxide-based transparent conductive film (I), by switching to an oxide sintered body target consisting of zinc oxide as a major component and at least one or more kinds of added metal elements selected from aluminum and gallium.

In addition, according to a twentieth aspect of the present invention, there is provided the method for producing the transparent conductive film laminated body in the nineteenth aspect, **characterized in that** the indium oxide-based transparent conductive film (I) is formed as an amorphous film, under condition of a substrate temperature of equal to or lower than 100°C and a sputtering gas pressure of 0.1 to 1.0 Pa, and subsequently crystallized by heat treatment at 200 to 400°C.

Still more, according to a twenty-first aspect of the present invention, there is provided the method for producing the transparent conductive film laminated body in nineteenth aspect, **characterized in that** the indium oxide-based transparent conductive film (I) is formed as a crystalline film, under condition of a substrate temperature of 200 to 400°C and a sputtering gas pressure of 0.1 to 1.0 Pa.

On the other hand, according to a twenty-second aspect of the present invention, there is provided a silicon-based thin film solar cell, wherein the transparent conductive film in any one of the first to the sixth aspects, or the transparent conductive film laminated body in any one of the eighth to the seventeenth aspects is formed on a translucent substrate, at least one kind of a unit selected from one conducting type semiconductor layer unit, a photoelectric conversion layer unit, and other conducting type semiconductor layer unit, is arranged on said transparent conductive film or said transparent conductive film laminated body, and a back surface electrode layer is arranged on said unit.

According to the present invention, the transparent conductive film superior in hydrogen reduction resistance, surface irregularity, high haze ratio, as well as high conductivity can be provided, because of consisting of zinc oxide as a major component and at least one or more kinds of added metal elements selected from aluminum and gallium, in a specific amount, and having a surface roughness (Ra) of 35.0 nm to 70 nm, and a surface resistance of more than 0 Ω/□ and equal to or lower than 65Ω/□.

Still more, because this transparent conductive film can be produced by only the sputtering method, it is superior as a surface transparent electrode of the thin film solar cell, and is industrially useful. In addition, the surface transparent electrode of the thin film solar cell with lower resistance can be obtained by laminating the above transparent conductive film on other transparent conductive film having lower resistance to make a transparent conductive film laminated body, and said transparent conductive film laminated body can be provided in lower price as compared with the transparent conductive film by a conventional thermal CVD method. Therefore, it is industrially extremely useful, because a silicon-based thin film solar cell with high efficiency can be provided by a simple process and in low price.

Figure 1 is an illustrative drawing showing a schematic composition of a silicon-based thin film solar cell of the present invention, using an amorphous silicon thin film as a photoelectric conversion unit.

Figure 2 is an illustrative drawing showing a schematic composition of a silicon-based hybrid thin film solar cell of the present invention, in which an amorphous silicon thin film and a crystalline silicon thin film are laminated as a photoelectric conversion unit.

Figure 3 is a graph showing relation of contents of aluminum and gallium, in a transparent conductive film of the present invention.

Figure 4 is a surface SEM photo of a transparent conductive thin film obtained by a production method of the present invention.

1     Translucent substrate
2     Surface transparent electrode layer
3     Amorphous photoelectric conversion unit

4    Crystalline photoelectric conversion unit

5    Back surface electrode

Explanation will be given below in detail on the transparent conductive film, the transparent conductive film laminated body and the production method therefor, and the silicon-based thin film solar cell, with reference to drawings.

1. The zinc oxide-based transparent conductive film

The transparent conductive film of the present invention is characterized by consisting of zinc oxide as a major component and at least one or more kinds of added metal elements selected from aluminum and gallium, whose content being within a range shown by the following expression (1), and having a surface roughness (Ra) of 35.0 nm to 70 nm, and a surface resistance of more than 0 $\Omega/\square$ and equal to or lower than 65 $\Omega/\square$

$$-[\text{Al}]+0.30\leq[\text{Ga}]\leq-2.68\times[\text{Al}]+1.74 \quad --- \quad (1)$$

(wherein [Al] represents aluminum content expressed as atomic ratio (%) of Al/(Zn+Al); while [Ga] represents gallium content expressed as atomic ratio (%) of Ga/(Zn+Ga))wherein said transparent conductive film is obtainable by a sputtering method, using an oxide sintered body target consisting of zinc oxide as a major component and at least one or more kinds of added metal elements selected from aluminum and gallium, wherein the film formation is performed in high speed, by setting a direct current input power density of equal to or higher than 1. 66 W/cm$^2$ to the aforesaid oxide sintered body target, under condition of a sputtering gas pressure of 2.0 to 15.0 Pa, and a substrate temperature of 200 to 500 °C.

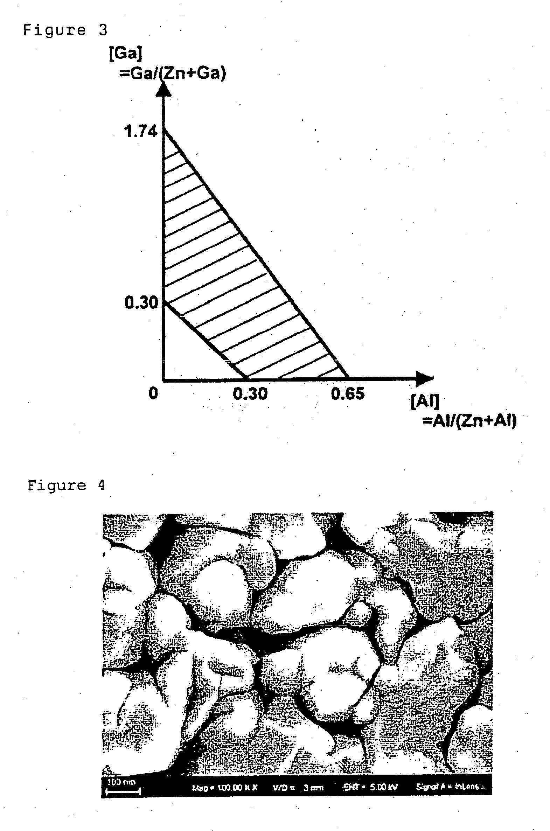

In the transparent conductive film of the present invention, a content of aluminum [Al] and a content of gallium [Ga] should be in relation shown by the expression (1), and composition thereof should be within a range of an oblique line part of Fig. 3.

The content of aluminum and gallium in the transparent conductive film of more than the range specified by the expression (1) provides easy diffusion of aluminum and gallium in the silicon-based thin film formed on said transparent conductive film, and generates a problem of not attainable the silicon-based thin film solar cell with superior characteristics. In addition, in view of productivity, the content of aluminum and gallium in said transparent conductive film of more than the range specified by the expression (1) results in making impossible to produce the transparent conductive film with large surface irregularity and high haze ratio in high speed by a sputtering method. On the other hand, the content of less than the range specified by the expression (1) results in insufficient conductivity, which makes impossible utilization as a surface transparent electrode of the solar cell.

The surface roughness (Ra) of the transparent conductive film of the present invention is 35.0 nm to 70 nm. The surface roughness (Ra) below 35.0 nm cannot provide the zinc oxide-based transparent conductive film with high haze ratio, and provides inferior optical confinement effect when the silicon-based thin film solar cell is produced, and cannot attain high conversion efficiency. A surface roughness (Ra) of said transparent conductive film over 70 nm affects growth of a silicon-based thin film to be formed on said transparent conductive film, deteriorates contact between said transparent conductive film and the silicon-based thin film caused by generation of a gap at the interface, deteriorates characteristics of the solar cell, and thus is not preferable.

According to NON-PATENT LITERATURE 2, a film with increased addition amount of Al and surface irregularity cannot be formed unless in low speed. Film formation in high speed results in decrease in the surface irregularity. Desired shape of the surface irregularity also cannot be obtained by film formation in high speed. Decreased addition amount of Al in the transparent conductive film has not been investigated at all up to now, because it leads to increase in resistance value, and the surface irregularity or shape thereof of the film had not been investigate as well, in the case of increasing film formation speed. The surface irregularity of the transparent conductive film of the present invention is largely different from shape obtained in a range of NON-PATENT LITERATURE 2.

In addition, the surface resistance of the transparent conductive film of the present invention is more than 0 $\Omega/\square$ and equal to or lower than 65$\Omega/\square$. The surface resistance over 65$\Omega/\square$ increases power loss at the surface electrode, in utilization as the surface electrode of the solar cell, and cannot attain the solar cell with high efficiency. The transparent conductive film of the present invention can have the surface resistance of equal to or lower than 65$\Omega/\square$ by taking such a film composition as described above. The surface resistance of the zinc oxide-based transparent conductive film of the present invention is preferably equal to or lower than 20$\Omega/\square$, and still more preferably equal to or lower than 15 $\Omega/\square$.

The zinc oxide-based transparent conductive film used as the surface electrode can attain the solar cell with high efficiency, even by large cell area, because the lower surface resistance provides the smaller power loss at the surface electrode part, and thus is preferable. This can be attained by making the zinc oxide-based transparent conductive film a crystalline film. On the contrary, the high surface resistance of the surface electrode increases power loss at the surface electrode to an unignorable level, in the case of large cell size of the solar cell, which thus requires decrease in cell area and wiring of many small-type cells with metal wiring having low resistance so as to increase the area. The surface electrode having the surface resistance of equal to or lower than 65 $\Omega/\square$ can attain the solar cell with at least 5 cm$\square$; the surface resistance of equal to or lower than 20 $\Omega/\square$ can attain the solar cell with at least 8 cm$\square$; and still more the surface resistance of equal to or lower than 15 $\Omega/\square$ can attain the solar cell with at least 12 cm$\square$, without considering influence of power loss at the surface electrode.

The solar cell with small cell area requires connection with metal wiring, which has a problem of not only lowering of generation amount per unit area of one module prepared by cell connection, caused by an increased cell gap, but also increasing production cost per unit cell area, and thus is not preferable.

The haze ratio of the zinc oxide-based transparent conductive film of the present invention is preferably set at equal to or higher than 8%. As described above, because the zinc oxide-based transparent conductive film of the present invention has the surface roughness (Ra) 35.0 nm to 70 nm, the haze ratio of equal to or higher than 8% can also be attained. The haze ratio is preferably equal to or higher than 10%, and more preferably equal to or higher than 16%. The higher haze ratio provides the more superior optical confinement effect, and thus can attain a solar cell with the higher efficiency. This can be attained by film formation of the zinc oxide-based transparent conductive film under sputtering condition to be described later. In comparing with a solar cell having the same structure, position showing increased conversion efficiency caused by optical confinement effect, relative to a surface electrode with the haze ratio of approximately 0%, is in the surface electrode with the haze ratio of equal to or higher than 8%. In a standard silicon-based thin film solar cell having a single structure, in order to attain the conversion efficiency of equal to or higher than 8%, the haze ratio of equal to or higher than 10% is essential. In addition, in similar evaluation, in order to attain the conversion efficiency of equal to or higher than 12%, use of a surface electrode with the haze ratio of equal to or higher than 16% is effective.

The zinc oxide-based transparent conductive film of the present invention is superior in hydrogen reduction resistance, has surface irregularity, high haze ratio, and high conductivity, as well as can be produced by only the sputtering method, therefore it is superior as the transparent conductive film for the surface transparent electrode of the thin film solar cell.

2. A production method for the zinc-oxide based transparent conductive film

A method for producing the zinc-oxide based transparent conductive film of the present invention is a method for producing the transparent conductive film for forming the zinc-oxide based transparent conductive film (II) on a substrate, by a sputtering method, using an oxide sintered body target consisting of zinc oxide as a major component and at least one or more kinds of added metal elements selected from aluminum and gallium, characterized by performing film formation in high speed, by setting a direct current input power density of equal to or higher than 1.66 W/cm$^2$ to the aforesaid oxide sintered body target, under condition of a sputtering gas pressure of 2.0 to 15.0 Pa, and a substrate temperature of 200 to 500°C.

In the present invention, as a target, the oxide sintered body consisting of zinc, aluminum and gallium is used, in which the content of aluminum and gallium is within a range shown by the following expression (1):

$$-[Al]+0.30 \leq [Ga] \leq -2.68 \times [Al]+1.74 \quad --- \quad (1)$$

(wherein [Al] represents aluminum content expressed as atomic ratio (%) of Al/(Zn+Al); while [Ga] represents gallium content expressed as atomic ratio (%) of Ga/(Zn+Ga)).

When the content of aluminum and gallium is within the range specified by the expression (1), the zinc oxide-based transparent conductive film of the present invention having large surface irregularity and high haze ratio as above can be produced in high speed by the sputtering method.

It should be noted that, when the content of aluminum and gallium is more than the range specified by the expression (1) (the upper right range from the oblique line part region of Fig. 3), a film having large surface irregularity cannot be obtained by the sputtering method in high speed, while when the content of aluminum and gallium is less than the range specified by the expression (1) (the lower left range from the oblique line part region of Fig. 3), only a film with insufficient conductivity is obtained, and thus in any of these cases, the film cannot be utilized as the surface transparent electrode of the solar cell.

The increased addition amount of a material with high melting point such as aluminum oxide or gallium oxide to zinc oxide retards crystal growth of the film in film formation, therefore input power to the target is increased to increase supply amount of sputtering particles onto the substrate, which in turn inhibits increase in irregularity caused by crystal growth. Such a composition of aluminum and gallium as above is capable of providing a film with large crystal grains of the film and large surface irregularity, even in high speed film formation by a high input power of equal to or higher than 1. 66 W/cm$^2$.

This oxide sintered body can be produced by adding and mixing gallium oxide powder and aluminum oxide powder to zinc oxide powder, as raw material powder, then subsequently pulverizing and mixing treating the resultant slurry obtained by blending an aqueous medium to this raw material powder, then molding the resultant mixture, and after that firing the molded body. Description on the detailed production method has been given in the above PATENT LITERATURE 3.

It should be noted that, in this oxide sintered body, other than zinc or aluminum or gallium or oxygen, other elements (for example, indium, titanium, tungsten, molybdenum, iridium, ruthenium, rhenium, cerium, magnesium, silicon, fluorine and the like) may be contained within a range not to impair objects of the present invention.

In the present invention, the zinc oxide-based transparent conductive film having large surface irregularity and high haze ratio can be produced in high speed, by setting a sputtering gas pressure at 2.0 to 15.0 Pa, and a substrate temperature at 200 to 500°C. Film formation in high speed means to perform sputtering film formation by increasing input power to the target to equal to or higher than 1.66 W/cm$^2$. In this way, the zinc oxide-based transparent conductive film having large surface irregularity and high haze ratio can be produced, for example, even in high speed film formation at equal to or higher than 40 nm/min, in static opposing film formation. It should be noted that, use of such a target as also used in NON-ATENT LITERATURE 2, having a target composition over 3% by atom as Al/(Zn+Al), can provide only a film with poor surface irregularity and small haze ratio, when film formation is performed in high speed by increasing input power. In addition, also even in the use of a target, having a target composition over 2% by atom as Ga/ (Zn+Ga), can provide only a film with poor surface irregularity and small haze ratio, when film formation is performed in high speed by increasing input power.

It should be noted that, the present invention can also be applied to transfer film formation (passage-type film formation). In the passage-type film formation, in which film formation is performed by making the substrate passing on the target, the zinc oxide-based transparent conductive film with superior surface irregularity and high haze ratio can be obtained, even in high speed transfer film formation of 3.5 nm m/min, (resulting film thickness (nm) is calculated by dividing with carry rate (m/min)), for example, in which the film is formed under the similar input power density. It should be noted that, film formation speed in this case is not especially limited as long as object of the present invention can be attained.

In addition, the present invention can be applied to planer-type magnetron-system sputtering film formation using a plate-like target, and also to rotary-type magnetron-system sputtering film formation using a cylinder-shape target.

The sputtering gas pressure below 2.0 Pa makes difficult to obtain a film with large surface irregularity, and makes impossible to obtain a film with a Ra value of equal to or larger than 35.0 nm. On the other hand, the sputtering gas pressure over 15.0 Pa results in delaying film formation speed, and thus is not preferable. For example, in order to obtain a high film formation speed of equal to or higher than 40 nm/min, by inputting high power with a direct current input power density to the target of equal to or higher than 1.66 W/cm$^2$, in static opposing film formation, the sputtering gas pressure should be equal to or lower than 15.0 Pa.

Conductivity of the zinc oxide-based transparent conductive film largely depends on substrate heating temperature in film formation. It is because high temperature in substrate heating provides good crystallinity of the film and increases mobility of carrier electrons. In the present invention, it is preferable that the substrate is heated at 200 to 500 °C, and in particular, 300 to 500°C. Film formation under heating the substrate at high temperature provides good crystallinity of the resultant transparent conductive film and can attain superior conductivity caused by the above factor.

3. The transparent conductive film laminated body

The transparent conductive film of the present invention can be used as a transparent conductive film laminated body for the surface electrode of the thin film solar cell with lower resistance. In the transparent conductive film laminated body of the present invention, the above zinc oxide-based transparent conductive film (II) is formed on the surface of the indium oxide-based transparent conductive film (I) formed on the translucent substrate.

In the transparent conductive film laminated body of the present invention, the zinc oxide-based transparent conductive film (II) consists of zinc oxide as a major component and at least one or more kinds of added metal elements selected from aluminum and gallium, whose content being within a range shown by the following expression (1):

$$-[Al]+0.30 \leq [Ga] \leq -2.68 \times [Al] + 1.74 \quad --- \quad (1)$$

(wherein [Al] represents aluminum content expressed as atomic ratio (%) of Al/(Zn+Al); while [Ga] represents gallium content expressed as atomic ratio (%) of Ga/(Zn+Ga)).

The content of aluminum and gallium in the zinc oxide-based transparent conductive film of more than the range specified by the expression (1) provides easy diffusion of aluminum and gallium in the silicon-based thin film formed thereon, and cannot attain the silicon-based thin film solar cell with superior characteristics. In addition, in view of productivity, the content of aluminum and gallium in the film of more than the range specified by the expression (1) results in making impossible to produce the transparent conductive film with large surface irregularity and high haze ratio in high speed by a sputtering method. On the other hand, the content of less than the range specified by the expression (1) results in insufficient conductivity, which makes impossible utilization as a surface transparent electrode of the solar cell.

Surface roughness (Ra) of zinc oxide-based transparent conductive film of the present invention is 35.0 nm to 70 nm. The surface roughness (Ra) below 35.0 nm cannot provide zinc oxide-based transparent conductive film with high haze ratio, and thus provides inferior optical confinement effect and cannot attain high conversion efficiency, in preparation of a silicon-based thin film solar cell.

The surface roughness (Ra) of said transparent conductive film over 70 nm affects growth of the silicon-based thin film formed on said transparent conductive film, generates space at the interface between said transparent conductive film and the silicon-based thin film, and thus deteriorates contact between them, and deteriorates solar cell characteristics, and thus is not preferable.

Surface resistance of the transparent conductive film laminated body of the present invention is more that 0 $\Omega/\square$ and equal to or lower than 65$\Omega/\square$. The surface resistance over 65 $\Omega/\square$ increases power loss at the surface electrode, in applying to the surface electrode of the solar cell, and thus cannot attain the solar cell with high efficiency. The transparent conductive film laminated body of the present invention can take surface resistance of equal to or lower than 65$\Omega/\square$ because of having such a laminated structure as above.

Surface resistance of the transparent conductive film laminated body of the present invention is preferably equal to or lower than 20$\Omega/\square$, more preferably equal to or lower than 13$\Omega/\square$, still more preferably equal to or lower than 10$\Omega/\square$, and most preferably equal to or lower than 8$\Omega/\square$. Reason for attainable such surface resistance is that such a structure is adopted as the indium oxide-based transparent conductive film with the above characteristics is inserted to a base.

As described above, the zinc oxide-based transparent conductive film used as the surface electrode can attain the solar cell with high efficiency, even it has large cell area, because the lower surface resistance provides the smaller power loss at the surface electrode part, and thus is preferable. On the contrary, the high surface resistance of the surface electrode increases power loss at the surface electrode to an unignorable level, in the case of large cell size of the solar cell, which thus requires decrease in cell area and wiring of many small-size cells with metal wiring having low resistance so as to increase the area. The surface electrode having the surface resistance of equal to or lower than 65$\Omega/\square$ can attain the solar cell with at least 5cm$\square$, but the surface resistance of equal to or lower than 20$\Omega/\square$ can attain the solar cell with at least 8cm$\square$; and still more the surface resistance of equal to or lower than 13$\Omega/\square$ can attain the solar cell with at least 15cm$\square$, the surface resistance of equal to or lower than 10$\Omega/\square$ can attain the solar cell with at least 17cm$\square$, and the surface resistance of equal to or lower than 8$\Omega/\square$ can attain the solar cell with at least 20cm$\square$, without considering influence of power loss at the surface electrode. The solar cell with small cell area requires connection with metal wiring, which has a problem of not only lowering of generation amount per unit area of one module prepared by cell connection, caused by an increased cell gap, but also increasing production cost per unit cell area, and thus is not preferable.

In addition, the haze ratio of the transparent conductive film laminated body of the present invention is more preferably equal to or higher than 12%, still more preferably equal to or higher than 16%, and most preferably equal to or higher than 20%, and thus provides very high optical confinement effect. Reason for attaining such high haze ratio is that the indium oxide-based transparent conductive film with the above characteristics is inserted to a base. In a standard silicon-based thin film solar cell having a single structure, in order to attain the conversion efficiency of equal to or higher than 10%, the haze ratio of equal to or higher than 12% is essential. In addition, in similar evaluation, in order to attain the conversion efficiency of equal to or higher than 12%, use of a surface electrode with the haze ratio of equal to or higher than 16% is effective. Still more, in similar evaluation, in order to attain the conversion efficiency of equal to or higher than 15%, use of a surface electrode with the haze ratio of equal to or higher than 20% is effective. In the tandem-type silicon-based thin film solar cell with high efficiency, a surface electrode with the haze ratio of equal to or higher than 20% is particularly useful.

In addition, it is preferable that the zinc oxide-based transparent conductive film (II) in the transparent conductive film laminated body of the present invention is a crystalline film containing a hexagonal crystalline phase and has superior approximately c-axis orientation, with a c-axis inclination angle being equal to or smaller than 15 degree, in particular, equal to or smaller than 10 degree, relative to a vertical direction of a substrate.

In this way, the transparent conductive film laminated body with large surface roughness, high haze ratio as above and low resistance can be attained. In evaluation of orientation of a ZnO-based sputtering film with a conventional thin film X-ray diffraction measurement ($\theta$-$2\theta$), only a diffraction peak caused by c-axis orientation was measured and it has been judged that most parts belonged to c-axis orientation. It is because, in the conventional thin film XRD measurement, only diffraction caused by plane spacing of lattice planes (for example, (002) plane or (004) plane) of the c-axis direction was observed, even when the c-axis was inclined a little from a vertical direction of the substrate. However, the present applicants have clarified, from pursuit by measurement of an X-ray pole figure, that the c-axis of the film does not necessarily grow in the vertical direction of the substrate surface, but a little inclined relative to the vertical direction. In the case of the transparent conductive film laminated body such as in the present invention, high haze ratio can be attained, when it has superior approximate c-axis orientation, that is, inclination angle of the c-axis of the zinc oxide-based transparent conductive film (II) relative to the vertical direction of the substrate surface is equal to or smaller than 10 degree. And, still more, degree of the inclination of the c-axis of the zinc oxide-based transparent conductive film (II) of the transparent conductive film laminated body such as the present invention depends largely on production condition of the indium oxide-based transparent conductive film (I) of the base.

In order to obtain the transparent conductive film laminated body with lower resistance from the transparent conductive film laminated body of the present invention, the indium oxide-based transparent conductive film (I) should be used as the base of the zinc oxide-based transparent conductive film (II). That is, said indium oxide-based transparent conductive film (I) is a crystalline film consisting of indium oxide as a major component and at least one or more kinds of metal elements selected from Sn, Ti, W, Mo, and Zr. The crystalline film of indium oxide containing the addition element of Sn, Ti, W, Mo, or Zr is superior in conductivity, and thus is useful. In particular, containment of the element of Ti, W, Mo, or Zr can provide a film with high mobility. Therefore, low resistance is attained without increasing carrier concentration, and thus a film with low resistance and high transmittance from a visible region to a near infrared region can be attained.

In the case of consisting of indium oxide as a major component and Sn, the content ratio thereof is preferably equal to or lower than 15% by atom, as atomic ratio of Sn/(In+Sn), in the case of containing Ti, the content ratio thereof is preferably equal to or lower than 5.5% by atom, as atomic ratio of Ti/(In+Ti), in the case of containing W, the content ratio thereof is preferably equal to or lower than 4.3% by atom, as atomic ratio of W/(In+W), in the case of containing Zr, the content ratio thereof is preferably equal to or lower than 6.5% by atom, as atomic ratio of Zr/(In+Zr), and in the case of containing Mo, the content ratio thereof is preferably equal to or lower than 6.7% by atom, as atomic ratio of Mo/(In+Mo). Containment over this range provides high resistance, and thus is not useful.

In order to obtain the transparent conductive film laminated body of the present invention, it is desirable to adopt the following condition in forming the indium oxide-based transparent conductive film (I) of the base. That is, a crystalline film of the indium oxide-based transparent conductive film (I) is formed on a substrate, by a sputtering method, using an oxide sintered body target consisting of indium oxide as a major component containing at least one or more kinds of metal elements selected from Sn, Ti, W, Mo, and Zr, and then the zinc oxide-based transparent conductive film (II) is formed on the indium oxide-based transparent conductive film (I), by switching to an oxide sintered body target consisting of zinc oxide as a major component and at least one or more kinds of added metal elements selected from aluminum and gallium.

As a formation method for the indium oxide-based transparent conductive film (I), there are the first method for forming an amorphous film without heating a substrate, and then crystallizing it by heat treatment, and the second method for forming a crystalline film by heating the substrate.

In the first method, an amorphous film is formed, under condition of a substrate temperature of equal to or lower than 100°C and a sputtering gas pressure of 0.1 to 1.0 Pa, and subsequently it is crystallized by heat treatment at 200 to 400 °C to obtain the indium oxide-based transparent conductive film. In addition, in the second method, the indium oxide-based transparent conductive film is formed as the crystalline film under condition of a substrate temperature of 200 to 400°C and a sputtering gas pressure of 0.1 to 1.0 Pa.

In the present invention, as a formation method for the indium oxide-based transparent conductive film (I), similarly as in the zinc oxide-based transparent conductive film (II), planer-type magnetron-system sputtering film formation using a plate-like target can be applied, and also rotary-type magnetron-system sputtering film formation using a cylinder-shape target can be applied.

In the present invention, the first method, in which an amorphous film is formed without heating the substrate, is better than the second method, in which a crystalline film is formed by heating the substrate. It is because the first method can provide a film with larger surface roughness (Ra) and higher haze ratio.

The transparent conductive film laminated body obtained by such a production method is useful as a surface electrode of a highly efficient solar cell, due to having high haze ratio and low resistance value.

In the present invention, thickness of the transparent conductive film is not especially limited, and although it depends on a material composition, the indium oxide-based transparent conductive film (I) is 40 to 400 nm, and particularly preferably 45 to 300 nm, in addition, the zinc oxide-based transparent conductive film (II) is 500 to 1700 nm, and particularly preferably 700 to 1620 nm. The above transparent conductive film of the present invention has low resistance and high transmittance of solar ray containing from visible light to near infrared light covering a wavelength of 380 nm to 1200 nm, therefore it can extremely efficiently convert light energy of solar ray to electric energy.

4. The thin film solar cell

In the thin film solar cell of the present invention, the above transparent conductive film, or the above transparent conductive film laminated body is formed on a translucent substrate, and at least one kind of a unit selected from one conducting type semiconductor layer unit, a photoelectric conversion layer unit, and other conducting type semiconductor layer unit, is arranged on the aforesaid transparent conductive film or transparent conductive film laminated body, and a back surface electrode layer is arranged on said unit.

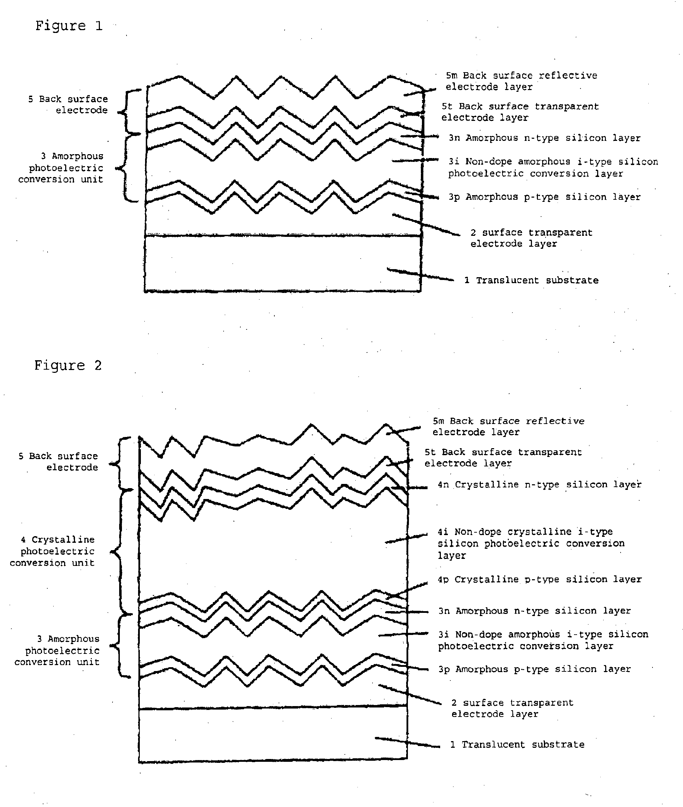

In general, a thin film solar cell contains a transparent conductive film, one or more semiconductor thin film photoelectric conversion units and a back surface electrode, laminated sequentially on a translucent substrate. And, one photoelectric conversion unit contains a p-type layer, an n-type layer and an i-type layer sandwiched between them. A structure of this representative silicon-based amorphous thin film solar cell is shown in Fig. 1.

The p-type or n-type conductive-type semiconductor layer fulfills a role of generating inner electric field inside the photoelectric conversion unit, and value of open circuit voltage(Voc), which is one of important characteristics of the thin film solar cell, depends on intensity of this inner electric field. The i-type layer is substantially an intrinsic semiconductor layer and occupies a large portion of thickness of the photoelectric conversion unit, and photoelectric conversion action generates mainly inside this i-type layer. Therefore, this i-type layer is usually called an i-type photoelectric conversion layer, or simply a photoelectric conversion layer. The photoelectric conversion layer is not limited to the intrinsic semiconductor layer, but may be a layer doped in the p-type or the n-type in trace amount within a range not to raise a loss problem of light absorbed by doped impurities (dopants).

In the silicon-based thin film solar cell using a silicon-based thin film as the photoelectric converting unit (a light absorbing layer), other than amorphous thin film solar cells, such one has also been practically used as a micro crystalline thin film solar cell, or a crystalline thin film solar cell, as well as a hybrid thin film solar cell obtained by laminating these. Here, the photoelectric converting unit or the thin film solar cell, as described above, in which the photoelectric converting layer occupying a major part thereof is amorphous is called an amorphous unit or an amorphous thin film solar cell, while one in which the photoelectric converting layer is crystalline is called a crystalline unit or a crystalline thin film solar cell, and one in which the photoelectric converting layer is micro crystalline is called a micro crystalline unit or a micro crystalline thin film solar cell.

As a method for enhancing conversion efficiency of such a thin film solar cell, there is a method for making a tandem-type solar cell by laminating two or more photoelectric conversion units. In this method, by arranging a front unit containing the photoelectric conversion layer having a large band gap at a light injection side of the thin film solar cell, and by arranging a rear unit containing the photoelectric conversion layer having a small band gap in order at the rear part thereof, photoelectric conversion over a wide wavelength range of injected light is made possible, and in this way, enhancement of conversion efficiency as the whole solar cell is attained. In this tandem-type solar cell, a representative structure of, in particular, a hybrid thin film solar cell, in which an amorphous photoelectric conversion unit and a crystalline or micro crystalline photoelectric conversion unit are laminated, is shown in Fig. 2. In the hybrid thin film solar cell, for example, wavelength of light, which the i-type amorphous silicon can convert photoelectrically, is up to about 800 nm, in a long wavelength side, however, the i-type crystalline or microcrystalline silicon can convert photoelectrically light up to about 1150 nm longer than that.

The transparent conductive film of the present invention can be produced using only the sputtering method, and can provide a transparent conductive film having high productivity, as well as superior hydrogen reduction resistance, surface irregularity, high haze ratio, and what is called superior optical confinement effect, along with low resistance, and still more can provide a transparent conductive film laminated body in which said transparent conductive film is laminated on other transparent conductive film with low resistance, that is, the indium oxide-based transparent conductive film (I). In addition, it is capable of providing a silicon-based thin film solar cell having said transparent conductive film or transparent conductive film laminated body, as an electrode.

In addition, the silicon-based thin film solar cell of the present invention has the above zinc oxide-based transparent conductive film with large surface irregularity, high haze ratio and low resistivity, or the above transparent conductive film laminated body, and is arranged thereon with at least one kind of a unit selected from one conducting type semiconductor layer unit, a photoelectric conversion layer unit, or other conducting type semiconductor layer unit, and is arranged thereon with a back surface electrode layer.

Explanation will be given next in more specifically on components of the silicon-based thin film solar cell of the present invention. In Figs. 1 and 2, on a translucent substrate 1, a zinc oxide-based transparent conductive film 2 of the present invention is formed. As the translucent substrate 1, a plate-like member or a sheet-like member composed of glass, a transparent resin or the like, is used. On the transparent conductive film 2, an amorphous photoelectric conversion unit 3 is formed. The amorphous photoelectric conversion unit 3 is composed of an amorphous p-type silicon carbide layer 3p, a non-doped amorphous i-type silicon photoelectric conversion layer 3i and an n-type silicon-based interface layer 3n. The amorphous p-type silicon carbide layer 3p is formed at a substrate temperature of equal to or lower than 180°C to prevent decrease in transmittance caused by reduction of the transparent conductive film 2.

In Fig. 2, on the amorphous photoelectric conversion unit 3, a crystalline photoelectric conversion unit 4 is formed. The crystalline photoelectric conversion unit 4 is composed of a crystalline p-type silicon layer 4p, a crystalline i-type silicon photoelectric conversion layer 4i and a crystalline n-type silicon layer 4n. For formation of the amorphous photoelectric conversion unit 3 and the crystalline photoelectric conversion unit 4 (hereafter, both of these are collectively referred to simply as a photoelectric conversion unit), a high frequency plasma CVD method is suitable. As formation condition of the photoelectric conversion unit, a substrate temperature of 100 to 250°C (however, for the amorphous p-type silicon carbide layer 3p, it is equal to or lower than 180°C), a pressure of 30 to 1500 Pa, and a high frequency power density of 0.01 to 0.5 W/cm$^2$ are preferably used. As raw material gas used in forming the photoelectric conversion unit, silicon-containing gas such as $SiH_4$, $Si_2H_6$, or a mixture of these gas and hydrogen is used. As dopant gas for forming the p-type or the n-type layer in the photoelectric conversion unit, $B_2H_6$ or $PH_3$ or the like is preferably used.

On the crystalline n-type silicon layer 4n of an interface layer, a back surface electrode 5 is formed. The back surface electrode 5 is composed of a back surface transparent electrode layer 5t and a back surface reflective electrode layer 5m. As the back surface transparent electrode layer 5t, a metal oxide obtained by conventional technology, such as ZnO or ITO, is enough, and as the back surface reflective electrode layer 5m, Ag, Al or an alloy thereof is preferably used. In forming the back surface electrode 5, a method such as sputtering or vapor deposition is preferably used. The back surface electrode 5 is usually set to have a thickness of 0.5 to 5 $\mu$m, and preferably 1 to 3 $\mu$m. It should be noted that, in Fig. 2, a structure of the hybrid thin film solar cell is shown, however, the photoelectric conversion unit is not necessarily present in two units, and it may be a single structure of amorphous or crystalline substance, or a laminated-type solar cell structure of three or more layers. After formation of the back surface electrode 5, by heating it under the vicinity of atmospheric pressure at an ambient temperature of equal to or higher than formation temperature of the amorphous p-type silicon carbide layer 3p, the silicone-based thin film solar cell of the present invention is completed. As vapor to be used as heating atmosphere, air, nitrogen, mixture of nitrogen and oxygen or the like is used preferably. In addition, the vicinity of atmospheric pressure shows a range of approximately 0.5 to 1.5 atm.

EXAMPLES

Explanation will be given below on the zinc oxide-based transparent conductive film according to the present invention with comparing Examples and Comparative Examples. It should be noted that, the zinc oxide-based transparent conductive film of the present invention should not be limited by these Examples.

(1) Film thickness was measured by the following procedure. Before film formation, a permanent marker was applied in advance on a part of a substrate, and after the film formation, the permanent marker was wiped off with ethanol to form a part not formed with the film and to determine by measuring the step difference between the parts with and without the film, using a contact-type surface shape measurement apparatus (Alpha-Step IQ, manufactured by KLA Tencor Co., Ltd.).

(2) In addition, composition of the resultant transparent conductive thin film was quantitatively analyzed by an ICP emission spectrometry (SPS4000, manufactured by Seiko Instruments Co., Ltd.).

(3) Crystallinity and orientation of the film were studied by X-ray diffraction measurement using an X-ray diffraction apparatus (M18XHF22, manufactured by Mac Science Co., Ltd.) utilizing CuK$\alpha$-ray.

(4) In addition, specific resistance of each transparent conductive thin film was measured by a four probe method using resistivity meter Roresta EP (MCP-T360 model, manufactured by Dia Instruments Co., Ltd.).

(5) Still more, total ray light transmittance and parallel ray transmittance, along with total ray reflectivity and parallel ray reflectivity, including the substrate, were measured using a spectrometer (U-4000, manufactured by Hitachi, Ltd.)

(6) Haze ratio of the film was evaluated using a haze meter (HM-150, manufactured by Murakami Color Research Laboratory), based on JIS K7136. Surface roughness (RA) of the film was measured on a region of 5 $\mu$m$\times$5 $\mu$m using an atomic force microscope (NS-III, D5000 system, manufactured by Digital Instruments Co., Ltd.).

(Examples 1 to 3)

A zinc oxide-based transparent conductive film with large surface irregularity was prepared as follows, using zinc oxide sintered body targets (manufactured by Sumitomo Metal Mining Co., Ltd.) containing aluminum as an addition element.

Composition of the targets used was quantitatively analyzed by an ICP emission spectrometry (SPS4000, manufactured by Seiko Instruments Co., Ltd.), and was 0.30 to 0.65% by atom as Al/(Zn+Al), as shown in Table 1. Any of the targets had a purity of 99.999% and a size of 6 inch ($\Phi$)$\times$5 mm (thickness).

This sputtering target was attached at a cathode (maximum horizontal magnetic field intensity, at the position apart from the target surface by 1 cm, was about 80 kA/m (1 kG)) for ferromagnetic target of a direct current magnetron sputtering apparatus (SPE503K, manufactured by Tokki Corp.), and a Corning 7059 glass substrate with a thickness of 1.1 mm was attached at the counterface surface of said sputtering target. It should be noted that, average light transmittance in a visible light wavelength region of the Corning 7059 glass substrate itself is 92%. Distance between the sputtering target and the substrate was set at 50 mm.

Next, inside of the chamber was subjected to vacuuming, and when vacuum degree thereof reached equal to or lower than $2\times10^{-4}$ Pa, argon gas with a purity of 99.9999% by mass was introduced into the chamber to set gas pressure at 3.0 Pa. Substrate temperature was set at 400°C, and a direct current input power of 400 W (input power density to the target= direct current input power ÷ target surface area=400 W 181 cm$^2$ =2.210 W/cm$^2$) was input between the target and the substrate to generate direct current plasma. After performing pre-sputtering for 10 minutes to clean the target surface, film formation by sputtering was performed while holding the substrate just above the center of the target. Because of high input power, film formation speed was as high as 68 to 70 nm/min.

Film thickness of the resultant transparent conductive film, composition, crystallinity of the film, orientation and specific resistance of each transparent conductive film were measured by the above-described methods. Still more, total ray light transmittance and parallel ray transmittance, along with total ray reflectivity and parallel ray reflectivity, including the substrate, and haze ratio of the film were measured by the above-described methods.

In Table 1, characteristics of the films obtained in Examples 1 to 3 are shown. Composition of the resultant film was nearly the same as composition of the target. In addition, film thickness was 830 to 850 nm. Surface roughness Ra measured with an atomic force microscope showed as high as 35.2 to 56.1 nm, and haze ratio was also as high as 8 to 12.5%, irrespective of the high film formation speed of 68 to 70 nm/min. From a surface SEM photo of the film of Example 2 shown in Fig. 4, it is understood that the film is composed of a large grain and has large surface irregularity. It was confirmed that the films of Example 1 and Example 3 also had similar surface texture. In addition, surface resistance was 43 to 63 Ω/□, showed high conductivity. Therefore, it was confirmed from Examples 1 to 3 that the zinc oxide-based transparent conductive film, having high haze ratio and superior conductivity, can be obtained in high speed.

(Comparative Examples 1 to 3)

A zinc oxide-based transparent conductive film was prepared from zinc oxide sintered body targets containing aluminum similarly, except that target composition was changed from Examples 1 to 3. As the targets, one having a composition thereof of 1.59% by atom (Comparative Example 1), 0.80% by atom (Comparative Example 2), and 0.20% by atom (Comparative Example 3) as Al/(Zn+Al), were used. All conditions other than the composition of the target were set the same as those in Examples 1 to 3.

In Table 1, characteristics of the resultant films are shown. Composition of the resultant films was nearly the same as composition of the target. In any cases, high film formation speed of 66 to 70 nm/min was obtained, because input power density to the target in film formation was set at same 2.210 W/cm$^2$, as in Examples 1 to 3. However, the films of Comparative Examples 1 and 2 had lower Ra value and lower haze ratio, different from those of Examples 1 to 3, although having good conductivity. Therefore, because of insufficient optical confinement effect, they cannot be utilized as a surface transparent electrode of a highly efficient solar cell. In addition, because the film of Comparative Example 3 had too high surface resistance, although having high Ra value and haze ratio, it cannot be utilized as an electrode of a solar cell.

(Examples 4 to 6)

Zinc oxide-based transparent conductive films with large surface irregularity were prepared, using zinc oxide sintered body targets containing gallium as an addition element. The zinc oxide-based transparent conductive films were obtained under similar condition as in Examples 1 to 3, except by using the zinc oxide sintered body targets containing gallium, as target composition of 1.74% by atom as Ga/(Zn+Ga) (Example 4), 0.87% by atom (Example 5), and 0.30% by atom (Example 5), a gas pressure of 8.0 Pa, and a substrate temperature of 300°C.

In Table 1, preparation condition of the films and characteristics of the resultant films are shown. Composition of the resultant films was nearly the same as composition of the target. The films of Examples 4 to 6 had a film thickness of 780 to 800 nm and formed in a high speed of about 71 nm/min, however, any of the Ra values of the films was as high as 48 to 56 nm, and also the haze ratios were as high as 10.8 to 12.1%, and surface resistances were within a range of 11 to 25 Ω/□, showing high conductivity. Therefore, such films can be utilized for the surface transparent electrode of the solar cell with superior optical confinement effect.

(Comparative Examples 4 to 6)

Zinc oxide-based transparent conductive films were prepared from zinc oxide sintered body targets containing gallium similarly as in Examples 4 to 6, however, the targets with a target composition of 3.48% by atom as Ga/(Zn+Ga) (Comparative Example 4), 2.62% by atom (Comparative Example 5), and 0.20% by atom (Comparative Example 6) were used. High film formation speed of 70 to 72 nm/min was obtained, because input power density to the target in film formation was also set at same 2.210 W/cm$^2$ as in Examples 1 to 3. Evaluation of the resultant films was performed similarly as in Examples 1 to 3.

In Table 1, characteristics of the resultant films are shown. Composition of the films was nearly the same as composition of the targets. The films of Comparative Examples 4 and 5 had lower Ra value and lower haze ratio, different from those of Examples 4 to 6, although having good conductivity. Therefore, because of insufficient optical confinement effect, they cannot be utilized as a surface transparent electrode of a highly efficient solar cell. In addition, because the film of Comparative Example 6 had too high surface resistance, although having high Ra value and haze ratio, it cannot be utilized as an electrode of a solar cell.

(Examples 7 to 10)

Zinc oxide-based transparent conductive films with large surface irregularity were prepared, using zinc oxide sintered body targets containing aluminum and gallium as addition elements. The zinc oxide-based transparent conductive films were obtained under similar condition as in Examples 1 to 3, except by using the zinc oxide sintered body targets containing aluminum and gallium, with target compositions shown in Table 1, a gas pressure of 5.0 Pa, and a substrate temperature of 350°C. In addition, evaluation of the resultant films was performed similarly as in Examples 1 to 3.

In Table 1, preparation condition of the films and characteristics of the resultant films are shown. Composition of the resultant films was nearly the same as composition of the target. The films of Examples 7 to 10 had a film thickness of 824 to 851 nm and formed in a high speed of about 69 nm/min, however, any of the Ra values of the films was as high as 38 to 50 nm, and also the haze ratios were as high as 8.5 to 12.1%, and surface resistances were within a range of 29 to 57 Ω/□, showing high conductivity. Therefore, such films can be utilized for the surface transparent electrode of the solar cell with superior optical confinement effect.

(Comparative Examples 7 to 9)

Zinc oxide-based transparent conductive films were prepared from zinc oxide sintered body targets containing aluminum and gallium similarly as in Examples 7 to 10, however, the targets with compositions of outside the composition range of the present invention, as shown in Table 1, were used. The zinc oxide-based transparent conductive films were prepared all under the same condition as in Examples 7 to 10, other than the target compositions. High film formation speed of 66 to 70 nm/min was obtained, because input power density to the target in film formation was also set at 2.210 W/cm$^2$, the same as in Examples 7 to 10. Evaluation of the resultant films was performed similarly as in Examples 1 to 3.

In Table 1, characteristics of the resultant films are shown. Composition of the films was nearly the same as composition of the targets. The films of Comparative Examples 7 and 8 had lower Ra value and lower haze ratio, different from those of Examples 7 to 10, although having good conductivity. Therefore, because of insufficient optical confinement effect, they cannot be utilized as a surface transparent electrode of a highly efficient solar cell. In addition, because the film of Comparative Example 9 had too high surface resistance, although having high Ra value and haze ratio, it cannot be utilized as an electrode of a solar cell.

(Comparative Examples 10 to 13)

Zinc oxide-based transparent conductive films were prepared from zinc oxide sintered body targets containing aluminum similarly as in Examples 1 to 3, however, the target with a target composition of 3.16% by atom as Al/(Zn+Al) was used. This target composition was also used in NON-PATENT DOCUMENT 2. Input power density to the target in film formation was changed within a range of 0.442 to 2.210 W/cm$^2$. The Zinc oxide-based transparent conductive films with a film composition of 3.18% by atom as Al/(Zn+Al) were prepared by performing film formation all under the same condition as in Examples 1 to 3, other than the target composition and input power. Characteristics evaluation of the resultant films was performed similarly as in Examples 1 to 3.

In Table 1, characteristics of the resultant films are shown. With increase in input power density to the target in film formation, film formation speed was increased. As shown in Comparative Example 10, in the case of low power charge of a input power to the target of 0.442 W/cm$^2$, the transparent conductive film with high Ra value and haze ratio, as well as satisfactory conductivity was obtained, and the same result as in NON-PATENT DOCUMENT 2 was obtained. However, in Comparative Example 10, because of low input power density, film formation speed was significantly slow and it thus is not practical. Comparative Examples 11 to 13 are examples in which input power density was increased further, however, with increase in input power density, haze ratio decreased significantly, and in 1.105 W/cm$^2$ (Comparative Example 11), a film with high haze ratio was not obtained.

(Comparative Examples 14 to 17)

Zinc oxide-based transparent conductive films were prepared from zinc oxide sintered body targets containing gallium similarly as in Examples 4 to 6. Film formation was performed under the same condition as in Examples 4 to 6, except by using a target with a target composition of 4.99% by atom as Ga/(Zn+Ga), a film formation gas pressure of 8.3 Pa, and by changing input power density to the target in film formation within a range of 0.442 to 2.210 W/cm$^2$. Zinc oxide-based transparent conductive films with a film composition of 5.03% by atom as Ga/(Zn+Ga) was obtained. Characteristics evaluation of the resultant films was performed similarly as in Examples 1 to 3.
In Table 1, characteristics of the resultant films are shown. With increase in input power density to the target in film formation, film formation speed increased, and Ra value and haze ratio of the film showed decreasing tendency. However, in any of the input power density, a film with high haze ratio, which can be utilized as the surface transparent electrode of the solar cell, was not obtained.

(Examples 11 to 13 and Comparative Example 18)

Zinc oxide-based transparent conductive films were prepared from zinc oxide sintered body targets containing gallium similarly as in Examples 4 to 6. The zinc oxide-based transparent conductive films, having a film thickness of 830 nm (Comparative Example 18), 1010 nm (Example 11), 1350 nm (Example 12), and 1620 nm (Example 13), were prepared using a target with a target composition of 1.31% by atom as Ga/(Zn+Ga), a film formation gas pressure of 5.5 Pa, and changing input power density to the target of 2.760 W/cm$^2$, and by changing film formation time. Characteristics evaluation of the resultant films was performed similarly as in Examples 1 to 3.
In Table 1, characteristics of the resultant films are shown. Composition of any of the films was 1.35% by atom as Ga/(Zn+Ga), nearly the same as composition of the targets. With increase in film thickness, surface resistance decreased, but Ra value and haze ratio also increased. The film of Comparative Example 18, although having sufficiently low surface resistance, had low haze ratio and weak optical confinement effect, therefore, it cannot be utilized as a surface transparent electrode of a highly efficient solar cell. However, because the films of Examples 11 to 13 have not only the low surface resistance but also the sufficiently high haze ratio of equal to or higher than 8%, they can be utilized as the surface transparent electrode of the highly efficient solar cell.

(Examples 14 to 16 and Comparative Examples 19 to 20)

Zinc oxide-based transparent conductive films were prepared from zinc oxide sintered body targets containing aluminum and gallium similarly as in Examples 7 to 10. The zinc oxide-based transparent conductive films were prepared under condition of a target composition of 0.28% by atom as Ga/ (Zn+Ga), 0.28% by atom as Al/ (Zn+Al), a input power density to the target of 1.660 W/cm$^2$, and a substrate temperature of 300°C, and by changing gas pressure so as to be 1.0 Pa (Comparative Example 19), 2.0 Pa (Example 14), 10.5 Pa (Example 15), 15.0 Pa (Example 16), and 20.0 Pa (Comparative Example 20). The zinc oxide-based transparent conductive films with approximately the same film thickness of 1340 to 1360 nm were prepared, by adjusting film formation time, in consideration of film formation speed under each gas pressure. Evaluation of the resultant films was performed similarly as in Examples 1 to 3.
In Table 1, film formation condition and characteristics of the resultant films are shown. Composition of the films was nearly the same as composition of the target. With increase in gas pressure, Ra value and haze ratio increased. The film of Comparative Example 19 had low haze ratio and weak optical confinement effect, therefore, it cannot be utilized as a surface transparent electrode of a highly efficient solar cell. The resultant film in Comparative Example 20 had very slow film formation speed in preparation and thus poor productivity, as well as high surface resistance and weak adhesive strength of the film to the substrate and thus is easily peeled, although having high haze ratio, therefore, it cannot be utilized as an electrode of a device. However, because the films of Examples 14 to 16 had not only the low surface resistance but also the sufficiently high haze ratio of equal to or higher than 8%, and high adhesive strength of the film, they can be utilized as the surface transparent electrode of the highly efficient solar cell.

(Examples 17 to 19 and Comparative Examples 21 to 22)

Zinc oxide-based transparent conductive films were prepared from zinc oxide sintered body targets containing gallium similarly as in Examples 4 to 6. The zinc oxide-based transparent conductive films were prepared, under condition of a target composition of 0.30% by atom as Ga/(Zn+Ga), a input power density to the target of 2.760 W/cm$^2$, and a gas

pressure of 6.0 Pa, and by changing a substrate temperature so as to be 150°C (Comparative Example 21), 200°C (Example 17), 400°C (Example 18), 500°C (Example 19) and 600°C (Comparative Example 22). The zinc oxide-based transparent conductive films with a film thickness of 1005 to 1012 nm were prepared, by adjusting film formation time, in consideration of different film formation speed at each film formation temperature. Characteristics evaluation of the resultant films was performed similarly as in Examples 1 to 3.

In Table 1, film formation condition and characteristics of the resultant films are shown. Composition of any of the films was 0.31% by atom as Ga/(Zn+Ga), nearly the same as composition of the target. With increase in substrate temperature, Ra value and haze ratio also increased, but surface resistance also increased. The film of Comparative Example 21, although having sufficiently low surface resistance, had low haze ratio and weak optical confinement effect, therefore, it cannot be utilized as a surface transparent electrode of a highly efficient solar cell. The resultant film of Comparative Example 22 had very slow film formation speed in preparation and thus poor productivity, as well as high surface resistance, although having high haze ratio, and thus cannot be utilized as the transparent electrode of the solar cell. However, because the films of Examples 17 to 19 have not only the low surface resistance but also the sufficiently high haze ratio of equal to or higher than 8%, they can be utilized as the surface transparent electrode of the highly efficient solar cell

(Examples 20 to 26)

According to the following procedure, a transparent conductive film with large surface irregularity having a structure, in which the Zinc oxide-based transparent conductive film was formed on the indium oxide-based transparent conductive film containing tin, was prepared by a sputtering method.

Composition of the targets used in preparation of the indium oxide-based transparent conductive film of the base, was quantitatively analyzed by an ICP emission spectrometry (SPS4000, manufactured by Seiko Instruments Co., Ltd.), and was 9.29% by atom as Sn/(In+Sn), as shown in Table 2. The targets had a purity of 99.999% and a size of 6 inch ($\Phi$) $\times$ 5 mm (thickness). Film formation was performed using an apparatus used in the zinc oxide-based transparent conductive films of Examples 1 to 19, and also with the same cathode type. A Corning 7059 glass substrate with a thickness of 1.1 mm was attached at the counterface surface of the target. It should be noted that average light transmittance in a visible light wavelength region of the Corning 7059 glass substrate itself is 92%. Distance between the sputtering target and the substrate was set at 50 mm.

When vacuum degree in a chamber reached equal to or lower than $2\times10^{-4}$ Pa, argon gas mixed with 6% by volume of $O_2$ gas was introduced into the chamber to set gas pressure at 0.6 Pa, and while heating the substrate temperature up to 300°C, a direct current input power of 300 W (input power density to the target= direct current input power $\div$ target surface area=300 W $\div$ 181 sq=1.660 W/cm$^2$) was input between the target and the substrate to generate direct current plasma. After performing pre-sputtering for 10 minutes to clean the target surface, film formation by sputtering was performed while holding the substrate just above the center of the target, to form the indium oxide-based transparent conductive film with a film thickness of 150 nm. It should be noted that, the indium oxide-based transparent conductive film prepared by this method is a crystalline film, having a surface roughness of 1.32 nm.

On this indium oxide-based transparent conductive film, zinc oxide-based transparent conductive film was formed as described in follows. That is, in Example 20, the zinc oxide-based transparent conductive film was formed similarly as in Example 1; in Example 21, the zinc oxide-based transparent conductive film was formed similarly as in Example 3; in Example 22, the zinc oxide-based transparent conductive film was formed similarly as in Example 4; in Example 23, the zinc oxide-based transparent conductive film was formed similarly as in Example 6; in Example 24, the zinc oxide-based transparent conductive film was formed similarly as in Example 7; in Example 25, the zinc oxide-based transparent conductive film was formed similarly as in Example 9; and in Example 26, the zinc oxide-based transparent conductive film was formed similarly as in Example 10; to obtain the transparent conductive film laminated bodies. Compositions thereof are shown in Table 2. As characteristics evaluation of the transparent conductive film laminated bodies prepared, evaluation of pole figure was also performed by X-ray diffraction measurement (X' Pert Pro MPD, manufactured by PANalytical Co., Ltd.), in addition to similar items performed in the zinc oxide-based transparent conductive films of Examples 1 to 3, to evaluate by how much degree the c-axis of the zinc oxide-based transparent conductive film is inclined relative to a vertical direction of the substrate.

In Table 2, characteristics evaluation results of the transparent conductive film laminated bodies of Examples 20 to 26 are shown. Film composition of any of the indium oxide-based transparent conductive film of the base, was nearly the same as composition of the target, and as for film formation speed of the zinc oxide-based transparent conductive film, nearly the same high film formation speed as in not inserting the indium oxide-based transparent conductive film as the base, was attained. The resultant transparent conductive film laminated bodies had extremely decreased surface resistance as compared with the case of not inserting the indium oxide-based transparent conductive film as the base. Surface roughness and haze ratio of the transparent conductive film laminated bodies of Examples 20 to 26 showed somewhat decreasing tendency as compared with the case of not inserting the indium oxide-based transparent conductive film as the base, however, showed sufficiently high value in utilizing as the surface transparent electrode of the solar cell. The c-axis of the zinc oxide-based transparent conductive film was inclined by equal to or smaller than 15 degree relative to a vertical direction of the substrate.

Such films can be utilized for the surface transparent electrode of the solar cell with superior optical confinement effect.

(Comparative Examples 23 to 26)

Similarly as in Examples 20 to 26, on the indium oxide-based transparent conductive film as the base, the zinc oxide-based transparent conductive film was formed as described in follows to prepare the transparent conductive film laminated bodies. That is, in Comparative Example 23, the zinc oxide-based transparent conductive film was formed similarly as in Comparative Example 2; in Comparative Example 24, the zinc oxide-based transparent conductive film was formed similarly as in Comparative Example 3; in Comparative Example 25, the zinc oxide-based transparent conductive film was formed similarly as in Comparative Example 8; and in Comparative Example 26, the zinc oxide-based transparent conductive film was formed similarly as in Comparative Example 9; to obtain the transparent conductive film laminated bodies. Compositions thereof are shown in Table 2. As characteristics evaluation of the transparent conductive film laminated bodies prepared, evaluation of pole figure was also performed by X-ray diffraction measurement, similarly as in the zinc oxide-based transparent conductive films of Examples 1 to 3.

In Table 2, characteristics evaluation results of the transparent conductive film laminated bodies of Comparative Examples 23 to 26 are shown. The transparent conductive film laminated bodies of Comparative Examples 23 to 26 had decreased surface resistance as compared with the case of not inserting the indium oxide-based transparent conductive film as the base, however, showed tendency of having a surface roughness Ra value and haze ratio of the transparent conductive film laminated bodies equal to or lower than as compared with the case of not inserting the indium oxide-based transparent conductive film, as the base. The transparent conductive film laminated bodies of Comparative Examples 23 and 25 showed low haze ratio and weak optical confinement effect, although having sufficiently low surface resistance, and thus cannot be utilized as the surface transparent electrode of the highly efficient solar cell. The transparent conductive film laminated bodies of Comparative Examples 24 and 26 had extremely high surface resistance, and thus cannot be utilized as the surface transparent electrode of the highly efficient solar cell. Therefore, these films cannot be utilized for the surface transparent electrode of the solar cell with superior optical confinement effect.

(Examples 27 to 33)

The indium oxide-based transparent conductive film of the base, shown in Examples 20 to 26, was prepared under the same condition, except by changing to a method for film formation without heating the substrate and then annealing under vacuum, instead of film formation under heating. Annealing condition was set at 300 to 400°C for 30 to 60 minutes in vacuum, as shown in Table 2. It should be noted that, the indium oxide-based transparent conductive film prepared by this method is a crystalline film in any case, having a surface roughness of 1.3 to 2.1 nm.

On this indium oxide-based transparent conductive film, zinc oxide-based transparent conductive film described as described in follows was formed. That is, in Example 27, the zinc oxide-based transparent conductive film was formed similarly as in Example 1; in Example 28, the zinc oxide-based transparent conductive film was formed similarly as in Example 3; in Example 29, the zinc oxide-based transparent conductive film was formed similarly as in Example 4; in Example 30, the zinc oxide-based transparent conductive film was formed similarly as in Example 6; in Example 31, the zinc oxide-based transparent conductive film was formed similarly as in Example 7; in Example 32, the zinc oxide-based transparent conductive film was formed similarly as in Example 9; and in Example 33, the zinc oxide-based transparent conductive film was formed similarly as in Example 10 to obtain the transparent conductive film laminated bodies. Compositions thereof are shown in Table 2. As characteristics evaluation of the transparent conductive film laminated bodies prepared, evaluation of pole figure was also performed by X-ray diffraction measurement, in addition to similar items performed in the zinc oxide-based transparent conductive films of Examples 1 to 3.

In Table 2, characteristics evaluation results of the transparent conductive film laminated bodies of Examples 27 to 33 are shown. Film composition of any of the indium oxide-based transparent conductive film of the base, was nearly the same as composition of the target, and as for film formation speed of the zinc oxide-based transparent conductive film, nearly the same high film formation speed as in not inserting the indium oxide-based transparent conductive film as the base, was attained. As shown in Table 2, the transparent conductive film laminated bodies had extremely decreased surface resistance as compared with the case of not inserting the indium oxide-based transparent conductive film as the base, and had increased surface roughness Ra value and haze ratio as well.

From comparisons between Example 20 and Example 27, Example 21 and Example 28, Example 22 and Example 29, Example 23 and Example 30, Example 24 and Example 31, Example 25 and Example 32, along with Example 26 and Example 33, it is understood that the case of using the indium oxide-based transparent conductive film, which was subjected to annealing treatment after film formation without heating the substrate, as the base, (Examples 27 to 33) provides a film with increased surface roughness Ra value and haze ratio, as compared with the case of using the indium oxide-based transparent conductive film obtained by film formation under heating, as the base, (Examples 20 to 26).

Therefore, such transparent conductive film laminated bodies can be utilized for the surface transparent electrode of the solar cell with superior optical confinement effect.

(Comparative Examples 27 to 30)

By a similar procedure as in Examples 27 to 33, the transparent conductive film laminated bodies were prepared, and composition thereof was set as follows. That is, in Comparative Example 27, the zinc oxide-based transparent conductive film was formed similarly as in Comparative Example 2, on the indium oxide-based transparent conductive film formed under condition of Examples 27 to 28; in Comparative Example 28, the zinc oxide-based transparent conductive film of Comparative Example 3 was formed, on the indium oxide-based transparent conductive film formed under condition of Examples 27 to 28; in Comparative Example 29, the zinc oxide-based transparent conductive film of Comparative Example 5 was formed, on the indium oxide-based transparent conductive film formed under condition of Examples 29 to 30; and in Comparative Example 30, the zinc oxide-based transparent conductive film of Comparative Example 6 was formed, on the indium oxide-based transparent conductive film formed under condition of Examples 27 to 28; to obtain the transparent conductive film laminated bodies. As characteristics evaluation of the transparent conductive film laminated bodies prepared, evaluation of pole figure was also performed by X-ray diffraction measurement, in addition to similar items performed in the zinc oxide-based transparent conductive films of Examples 1 to 3.

In Table 2, characteristics evaluation results of the transparent conductive film laminated bodies of Comparative Examples 27 to 30 are shown. The transparent conductive film laminated bodies of Comparative Examples 27 to 30 had decreased surface resistance as compared with the case of not inserting the indium oxide-based transparent conductive film, as the base. However, the transparent conductive film laminated bodies of Comparative Examples 27 and 29 had low haze ratio and weak optical confinement effect, although having sufficiently low surface resistance, and thus cannot be utilized as the surface transparent electrode of the highly efficient solar cell. The transparent conductive film laminated bodies of Comparative Examples 28 and 30 had extremely high surface resistance, although having increased Ra value and haze ratio, and thus cannot be utilized as the surface transparent electrode of the solar cell. Therefore, such films cannot be utilized for the surface transparent electrode of the highly efficient solar cell.

(Examples 34 to 37 and Comparative Example 31)

The transparent conductive film laminated bodies were prepared by changing composition of the indium oxide-based transparent conductive film used as the base of Examples 27 to 33. As shown in Table 2, target composition in preparing the indium oxide-based transparent conductive film was changed within a range of 0.20 to 17.56% by atom as Sn/(In+Sn). As film formation condition, film formation gas pressure was set at 0.3 Pa, argon gas mixed with 8% by volume of oxygen was used as film formation gas, and annealing was performed at 200°C for 30 minutes in vacuum, after film formation without heating the substrate. Composition of any of the base films obtained by this method was nearly equal to the target composition, as shown in Table 2. As for crystallinity of the film, in the case of Sn/(In+Sn) is 17.56% by atom (Comparative Example 31), it was a mixed film of crystalline and amorphous substances, but in the case where it is 0.20 to 14.95% by atom (Examples 34 to 37), it was a completely crystalline film. On this base film prepared in this way, the zinc oxide-based transparent conductive film of Example 17 was formed. As for film formation speed of the zinc oxide-based transparent conductive film, nearly the same high film formation speed as in not inserting the indium oxide-based transparent conductive film, as the base, was attained. Compositions thereof are shown in Table 2. As characteristics evaluation of the transparent conductive film laminated bodies prepared, evaluation of pole figure was also performed by X-ray diffraction measurement, in addition to similar items performed in the zinc oxide-based transparent conductive films of Examples 1 to 3.

In Table 2, characteristics evaluation results of the transparent conductive film laminated bodies are shown. Any of the transparent conductive film laminated bodies had nearly the same or smaller surface resistance, as compared with the case of not inserting the indium oxide-based transparent conductive film, as the base, showing sufficient conductivity. As for surface roughness Ra value and haze ratio of the laminated bodies, increasing tendency was observed by inserting the base film, in Examples 34 to 37, however, they decreased significantly in Comparative Examples 31. Reason for decrease in the Ra value and haze ratio in Comparative Examples 31 is that the base film was not a complete crystalline film.

Examples 34 to 37 showed sufficiently high values for enabling to be utilized as the surface transparent electrode of the solar cell with superior optical confinement effect. However, Comparative Examples 31 cannot be utilized for that object, because of having small haze ratio.

(Examples 38 to 44)

The transparent conductive film laminated bodies were prepared by changing the tin-containing indium oxide-based transparent conductive film, used as the base film in Examples 20 to 26, to titanium-containing indium oxide-based transparent conductive film. The indium oxide-based transparent conductive film of the base, was prepared under the following condition.

Composition of the targets used in preparation of the indium oxide-based transparent conductive film of the base, was quantitatively analyzed by an ICP emission spectrometry (SPS4000, manufactured by Seiko Instruments Co., Ltd.), and was 1.73% by atom as Ti/(In+Ti), as shown in Table 3. The target had a purity of 99.999% and a size of 6 inch ($\Phi$) $\times$ 5 mm (thickness) .

Film formation was performed using an apparatus used in the zinc oxide-based transparent conductive films of Examples 20 to 26, and also with the same cathode type. A Corning 7059 glass substrate with a thickness of 1.1 mm was attached at the counterface surface of the target. It should be noted that, average light transmittance in a visible light wavelength region of the Corning 7059 glass substrate itself is 92%. It should be noted that, distance between the sputtering target and the substrate was set at 50 mm. When vacuum degree inside a chamber reached equal to or lower than $2\times10^{-4}$ Pa, argon gas mixed with 6% by volume of $O_2$ gas was introduced into the chamber to set gas pressure at 0.4 Pa, and after heating the substrate up to 300°C, a direct current input power of 300 W (input power density to the target= direct current input power ÷ target surface area=300 W ÷ 181 cm$^2$=1.660 W/cm$^2$) was input between the target and the substrate to generate direct current plasma. After performing pre-sputtering for 10 minutes to clean the target surface, film formation by sputtering was performed while holding the substrate just above the center of the target to form the indium oxide-based transparent conductive film, with a film thickness of 200 nm, on the substrate. It should be noted that, the indium oxide-based transparent conductive film prepared by this method was a crystalline film having a surface roughness Ra of 1.80 nm.

On this indium oxide-based transparent conductive film, zinc oxide-based transparent conductive film was formed as described in follows. That is, in Example 38, the zinc oxide-based transparent conductive film was formed similarly as in Example 1; in Example 39, the zinc oxide-based transparent conductive film was formed similarly as in Example 3; in Example 40, the zinc oxide-based transparent conductive film was formed similarly as in Example 4; in Example 41, the zinc oxide-based transparent conductive film was formed similarly as in Example 6; in Example 42, the zinc oxide-based transparent conductive film was formed similarly as in Example 7; in Example 43, the zinc oxide-based transparent conductive film was formed similarly as in Example 9; and in Example 44, the zinc oxide-based transparent conductive film was formed similarly as in Example 10 to obtain the transparent conductive film laminated bodies. Compositions thereof are shown in Table 3. As characteristics evaluation of the transparent conductive film laminated bodies prepared, evaluation of pole figure was also performed by X-ray diffraction measurement, in addition to similar items performed in the zinc oxide-based transparent conductive films of Examples 1 to 3.

In Table 3, characteristics evaluation results of the transparent conductive film laminated bodies of Examples 38 to 44 are shown. In any case, film composition of the indium oxide-based transparent conductive film of the base, was nearly the same as composition of the target, and as for film formation speed of the zinc oxide-based transparent conductive film, nearly the same high film formation speed as in not inserting the indium oxide-based transparent conductive film, as the base, was attained. As shown in Table 3, the transparent conductive film laminated bodies had extremely decreased surface resistance as compared with the case of not inserting the indium oxide-based transparent conductive film, as the base. Surface roughness Ra value and haze ratio of the transparent conductive film laminated bodies of Examples 38 to 44 showed somewhat decreasing tendency as compared with the case of not inserting the indium oxide-based transparent conductive film, as the base, however, showed sufficiently high value in utilizing as the surface transparent electrode of the solar cell. Therefore, such films can be utilized for the surface transparent electrode of the solar cell with superior optical confinement effect.

(Comparative Examples 32 to 35)

On the indium oxide-based transparent conductive film prepared in Examples 38 to 44, as the base, the zinc oxide-based transparent conductive films were formed as described in follows to prepare the transparent conductive film laminated bodies. That is, in Comparative Example 32, the zinc oxide-based transparent conductive film was formed similarly as in Comparative Example 2; in Comparative Example 33, the zinc oxide-based transparent conductive film was formed similarly as in Comparative Example 3; in Comparative Example 34, the zinc oxide-based transparent conductive film was formed similarly as in Comparative Example 8; and in Comparative Example 35, the zinc oxide-based transparent conductive film was formed similarly as in Comparative Example 9; to obtain the transparent conductive film laminated bodies. Compositions thereof are shown in Table 3. As characteristics evaluation of the transparent conductive film laminated bodies prepared, evaluation of pole figure was also performed by X-ray diffraction measurement, in addition to similar items performed in the zinc oxide-based transparent conductive films of Examples 1 to 3.

In Table 3, characteristics evaluation results of the transparent conductive film laminated bodies of Comparative Examples 32 to 35 are shown. The transparent conductive film laminated bodies had decreased surface resistance as compared with the case of not inserting the indium oxide-based transparent conductive film, as the base, however, showed tendency of having a surface roughness Ra value and haze ratio of the transparent conductive film laminated bodies equal to or lower as compared with the case of not inserting the indium oxide-based transparent conductive film, as the base. The transparent conductive film laminated bodies of Comparative Examples 32 and 34 showed low haze ratio and weak optical confinement effect, although having sufficiently low surface resistance, and thus cannot be utilized as the surface transparent electrode of the highly efficient solar cell. The transparent conductive film laminated bodies of Comparative Examples 33 and 35 had extremely high surface resistance, although having high Ra value and haze ratio, and thus cannot be utilized as the surface transparent electrode of the highly efficient solar cell. Therefore, such films cannot be utilized for the surface transparent electrode of the highly efficient solar cell.

(Examples 45 to 51)

The indium oxide-based transparent conductive film, as the base in Examples 38 to 44, was prepared under the same condition, except by changing to a method for film formation without heating the substrate and then annealing under vacuum, instead of film formation under heating. Annealing condition was set at 300 to 400°C for 30 to 60 minutes in vacuum, as shown in Table 3. It should be noted that, the indium oxide-based transparent conductive film prepared by this method is a crystalline film in any case, having a surface roughness of 1.15 to 1.51 nm.

On this indium oxide-based transparent conductive film, zinc oxide-based transparent conductive film was formed as described in follows. That is, in Example 45, the zinc oxide-based transparent conductive film was formed similarly as in Example 1; in Example 46, the zinc oxide-based transparent conductive film was formed similarly as in Example 3; in Example 47, the zinc oxide-based transparent conductive film was formed similarly as in Example 4; in Example 48, the zinc oxide-based transparent conductive film was formed similarly as in Example 6; in Example 49, the zinc oxide-based transparent conductive film was formed similarly as in Example 7; in Example 50, the zinc oxide-based transparent conductive film was formed similarly as in Example 9; and in Example 51, the zinc oxide-based transparent conductive film was formed similarly as in Example 10 to obtain the transparent conductive film laminated bodies. These compositions are shown in Table 2 (3). As characteristics evaluation of the transparent conductive film laminated bodies prepared, evaluation of pole figure was also performed by X-ray diffraction measurement, in addition to similar items performed in the zinc oxide-based transparent conductive films of Examples 1 to 3.

In Table 3, characteristics evaluation results of the transparent conductive film laminated bodies of Examples 45 to 51 are shown. In any case, film composition of the indium oxide-based transparent conductive film of the base, was nearly the same as composition of the target, and as for film formation speed of the zinc oxide-based transparent conductive film, nearly the same high film formation speed as in not inserting the indium oxide-based transparent conductive film, as the base, was attained. In addition, as shown in Table 3, the transparent conductive film laminated bodies of Examples 45 to 51 had extremely decreased surface resistance as compared with the case of not inserting the indium oxide-based transparent conductive film, as the base, and had increased surface roughness Ra value and haze ratio as well.

In addition, from comparisons between Example 38 and Example 45, Example 39 and Example 46, Example 40 and Example 47, Example 41 and Example 48, Example 42 and Example 49, Example 43 and Example 50, along with Example 44 and Example 51, it is understood that the case of using the indium oxide-based transparent conductive film, which was subjected to annealing treatment after film formation without heating the substrate, as the base, (Examples 45 to 51) provides a film with increased surface roughness Ra value and haze ratio, as compared with the case of using the indium oxide-based transparent conductive film obtained by film formation under heating, as the base, (Examples 38 to 44).

Therefore, such films can be utilized for the surface transparent electrode of the solar cell with superior optical confinement effect.

(Comparative Examples 36 to 39)

By a similar procedure as in Examples 45 to 51, the transparent conductive film laminated bodies were prepared, and composition thereof was set as described follows. That is, in Comparative Example 36, the zinc oxide-based transparent conductive film was formed similarly as in Comparative Example 2, on the indium oxide-based transparent conductive film formed under condition of Examples 45 to 51; in Comparative Example 37, the zinc oxide-based transparent conductive film of Comparative Example 3 was formed, on the indium oxide-based transparent conductive film formed under condition of Examples 45 to 51; in Comparative Example 38, the zinc oxide-based transparent conductive film of Comparative Example 5 was formed, on the indium oxide-based transparent conductive film formed under condition of Examples 45 to 51; and in Comparative Example 39, the zinc oxide-based transparent conductive film of Comparative Example 6 was formed, on the indium oxide-based transparent conductive film formed under condition of Examples 45 to 51; to obtain the transparent conductive film laminated bodies. As characteristics evaluation of the transparent conductive film laminated bodies prepared, evaluation of pole figure was also performed by X-ray diffraction measurement, in addition to similarly performing evaluation as in the zinc oxide-based transparent conductive films of Examples 1 to 3.

In Table 3, characteristics evaluation results of the transparent conductive film laminated bodies of Comparative Examples 36 to 39 are shown. The transparent conductive film laminated bodies had decreased surface resistance as compared with the case of not inserting the indium oxide-based transparent conductive film, as the base. However, the transparent conductive film laminated bodies of Comparative Examples 36 and 38 had low haze ratio and weak optical confinement effect, although having sufficiently low surface resistance, and thus cannot be utilized as the surface transparent electrode of the highly efficient solar cell. The transparent conductive film laminated bodies of Comparative Examples 37 and 39 had extremely high surface resistance, although having increased. Ra value and haze ratio, and thus cannot be utilized as the surface transparent electrode of the solar cell. Therefore, such films cannot be utilized for the surface transparent electrode of the highly efficient solar cell.

(Examples 52 to 55 and Comparative Example 40)

The transparent conductive film laminated bodies were prepared by changing composition of the indium oxide-based transparent conductive film, used as the base of Examples 45 to 51. As shown in Table 3, target composition in preparing the indium oxide-based transparent conductive film was changed within a range of 0.35 to 7.25% by atom as Ti/ (In+Ti). As film formation condition, film formation gas pressure was set at 0.3 Pa, argon gas mixed with 7% by volume of oxygen was used as film formation gas, and annealing was performed at 300°C for 30 minutes in vacuum, after film formation without heating the substrate. Composition of any of the base films obtained by this method was nearly equal to the target composition. As for crystalinity of the film, in the case of Ti/(In+Ti) is 7.25% by atom (Comparative Example 40), it was a mixed film of crystalline and amorphous substances, but in the case where it is 0.35 to 5.50% by atom (Examples 52 to 55), it was a completely crystalline film. On this base film with a film thickness of 100 nm, prepared in this way, the zinc oxide-based transparent conductive film was formed similarly as in Example 14. As for film formation speed of the zinc oxide-based transparent conductive film, nearly the same high film formation speed as in not inserting the indium oxide-based transparent conductive film, as the base, was attained. Compositions thereof are shown in Table 3. As characteristics evaluation of the transparent conductive film laminated bodies prepared, evaluation of pole figure was also performed by X-ray diffraction measurement, in addition to similar items performed in the zinc oxide-based transparent conductive films of Examples 1 to 3.

In Table 3, characteristics evaluation results of the transparent conductive film laminated bodies are shown. Any of the transparent conductive film laminated bodies had nearly the same or smaller surface resistance, as compared with the case of not inserting the indium oxide-based transparent conductive film, as the base, showing sufficient conductivity. As for surface roughness Ra value and haze ratio of the laminated bodies, increasing tendency was observed by inserting the base film, in Examples 52 to 55, however, they decreased significantly in Comparative Examples 40. Reason for decrease in the Ra value and haze ratio in Comparative Examples 40 is that the base film was not a complete crystalline film.

Examples 52 to 55 showed sufficiently high values for enabling to be utilized as the surface transparent electrode of the solar cell with superior optical confinement effect. However, Comparative Examples 40 cannot be utilized for that object, because of having small haze ratio.

(Examples 56 to 59 and Comparative Example 41)

The transparent conductive film laminated bodies were prepared by using a tungsten-containing indium oxide-based transparent conductive film, as the base, and forming the zinc oxide-based transparent conductive film thereon. The indium oxide-based transparent conductive film of the base, was prepared by the following condition.

As shown in Table 4, target composition in preparing the indium oxide-based transparent conductive film was changed within a range of 0.30 to 5.01% by atom as W/(In+W). As film formation condition, film formation gas pressure was set at 0.3 Pa, argon gas mixed with 7% by volume of oxygen was used as film formation gas, a direct current power of 400 W was input, and annealing was performed at 300°C for 30 minutes in vacuum, after film formation without heating the substrate. Composition of the base films obtained by this method was nearly equal to the target composition in any case. As for crystalinity of the film, in the case of W/(In+W) is 5.01% by atom (Comparative Example 41), it was a mixed film of crystalline and amorphous substances, but in the case where it is 0.30 to 4.28% by atom (Examples 56 to 59), it was a completely crystalline film. On this base film with a film thickness of 180 nm, prepared in this way, the zinc oxide-based transparent conductive film of Example 6 was formed. As for film formation speed of the zinc oxide-based transparent conductive film, nearly the same high film formation speed as in not inserting the indium oxide-based transparent conductive film, as the base, was attained. Compositions thereof are shown in Table 4. As characteristics evaluation of the transparent conductive film laminated bodies prepared, evaluation of pole figure was also performed by X-ray diffraction measurement, in addition to similar items performed in the zinc oxide-based transparent conductive films of Examples 1 to 3.

In Table 4, characteristics evaluation results of the transparent conductive film laminated bodies are shown. Any of the transparent conductive film laminated bodies had nearly the same or smaller surface resistance, as compared with the case of not inserting the indium oxide-based transparent conductive film, as the base, showing sufficient conductivity. As for surface roughness Ra value and haze ratio of the laminated bodies, increasing tendency was observed by inserting the base film, in Examples 56 to 59, however, they decreased significantly in Comparative Examples 41. Reason for decrease in the Ra value and haze ratio in Comparative Examples 41 is that the base film was not a complete crystalline film.

The transparent conductive film laminated bodies of Examples 56 to 59 showed sufficiently high values for utilizing as the surface transparent electrode of the solar cell with superior optical confinement effect. However, the transparent conductive film laminated body of Comparative Examples 41 cannot be utilized for that object, because of having small haze ratio.

(Examples 60 to 63 and Comparative Example 42)

The transparent conductive film laminated bodies were prepared by using a zirconium-containing indium oxide-based transparent conductive film, as the base, and forming the zinc oxide-based transparent conductive film thereon. The indium oxide-based transparent conductive film of the base, was prepared by the following condition.

As shown in Table 4, target composition in preparing the indium oxide-based transparent conductive film was changed within a range of 0.25 to 7.05% by atom as Zr/(In+Zr). As film formation condition as shown in Table 4, film formation gas pressure was set at 0.2 Pa, argon gas mixed with 6% by volume of oxygen was used as film formation gas, a direct current power of 400 W was input, and annealing was performed at 400°C for 60 minutes in vacuum, after film formation without heating the substrate. Composition of the base films obtained by this method was nearly equal to the target composition in any case. As for crystalinity of the film, in the case of Zr/(In+Zr) is 7.05% by atom (Comparative Example 42), it was a mixed film of crystalline and amorphous substances, but in the case where it is 0.25 to 6.50% by atom (Examples 60 to 63), it was a completely crystalline film. On this base film with a film thickness of 300 nm, prepared in this way, the zinc oxide-based transparent conductive film was formed similarly as in Example 2. As for film formation speed of the zinc oxide-based transparent conductive film, nearly the same high film formation speed as in not inserting the indium oxide-based transparent conductive film, as the base, was attained. Compositions thereof are shown in Table 4. As characteristics evaluation of the transparent conductive film laminated bodies prepared, evaluation of pole figure was also performed by X-ray diffraction measurement, in addition to similar items performed in the zinc oxide-based transparent conductive films of Examples 1 to 3.

In Table 4, characteristics evaluation results of the transparent conductive film laminated bodies are shown. Any of the transparent conductive film laminated bodies had nearly the same or smaller surface resistance, as compared with the case of not inserting the indium oxide-based transparent conductive film, as the base, showing sufficient conductivity. As for surface roughness Ra value and haze ratio of the laminated bodies, increasing tendency was observed by inserting the base film, in Examples 60 to 63, however, they decreased significantly in Comparative Examples 42. Reason for decrease in the Ra value and haze ratio in Comparative Examples 42 is that the base film was not a complete crystalline film.

The transparent conductive film laminated bodies of Examples 60 to 63 showed sufficiently high values for utilizing as the surface transparent electrode of the solar cell with superior optical confinement effect. However, the transparent conductive film laminated body of Comparative Examples 42 cannot be utilized for that object, because of having small haze ratio.

(Examples 64 to 67 and Comparative Example 43)

The transparent conductive film laminated bodies were prepared by using a molybdenum-containing indium oxide-based transparent conductive film, as the base, and forming the zinc oxide-based transparent conductive film thereon. The indium oxide-based transparent conductive film of the base, was prepared by the following condition.

As shown in Table 4, target composition in preparing the indium oxide-based transparent conductive film was changed within a range of 0.25 to 7.50% by atom as Mo/(In+Mo) . As film formation condition as shown in Table 4, film formation gas pressure was set at 0.3 Pa, argon gas mixed with 7% by volume of oxygen was used as film formation gas, a direct current power of 400 W was input, and annealing was performed at 300°C for 30 minutes in vacuum, after film formation without heating the substrate. Composition of the base films obtained by this method was nearly equal to the target composition in any case. As for crystalinity of the film, in the case of Mo/(In+Mo) is 7.50% by atom (Comparative Example 43), it was a mixed film of crystalline and amorphous substances, but in the case where it is 0.25 to 6.85% by atom (Examples 64 to 67), it was a completely crystalline film. On this base film with a film thickness of 180 nm, prepared in this way, the zinc oxide-based transparent conductive film was formed similarly as in Example 11. As for film formation speed of the zinc oxide-based transparent conductive film, nearly the same high film formation speed as in not inserting the indium oxide-based transparent conductive film, as the base, was attained. Compositions thereof are shown in Table 4. As characteristics evaluation of the transparent conductive film laminated bodies prepared, evaluation of pole figure was also performed by X-ray diffraction measurement, in addition to similar items performed in the zinc oxide-based transparent conductive films of Examples 1 to 3.

In Table 4, characteristics evaluation results of the transparent conductive film laminated bodies are shown. Any of the transparent conductive film laminated bodies had nearly the same or smaller surface resistance, as compared with the case of not inserting the indium oxide-based transparent conductive film, as the base, showing sufficient conductivity. As for surface roughness Ra value and haze ratio of the laminated bodies, increasing tendency was observed by inserting the base film, in Examples 64 to 67, however, they decreased significantly in Comparative Examples 43. Reason for decrease in the Ra value and haze ratio in Comparative Examples 43 is that the base film was not a complete crystalline film.

The transparent conductive film laminated bodies of Examples 64 to 67 showed sufficiently high values for utilizing as the surface transparent electrode of the solar cell with superior optical confinement effect. However, the transparent conductive film laminated body of Comparative Examples 43 cannot be utilized for that object, because of having small haze ratio.

Table 1

| | Production condition of zinc-oxide based transparent conductive film | | | | | | |
|---|---|---|---|---|---|---|---|
| | Target composition | | Gas pressure (Pa) | Gas Type (Ar/ O2) | Input power density (W/ cm2) | Film formation speed (nm/min) | Subs-trate (°C) |
| | Al/ (Zn+Al) % by atom | Ga/ (Zn+Ga) % by atom | | | | | |
| Com. Expl. 1 | 1.59 | 0 | 3 | 100/0 | 2.21 | 66.8 | 400 |
| Com. Expl. 2 | 0.8 | 0 | | | | 68.1 | |
| Expl. 1 | 0.65 | 0 | | | | 68.6 | |
| Expl. 2 | 0.43 | 0 | | | | 69.5 | |
| Expl. 3 | 0.3 | 0 | | | | 69.8 | |
| Com. Expl. 3 | 0.2 | 0 | | | | 70.1 | |
| Com. Expl. 4 | 0 | 3.48 | 8 | 100/0 | 2.21 | 70.5 | 300 |
| Com. Expl. 5 | 0 | 2.62 | | | | 70.8 | |
| Expl. 4 | 0 | 1.74 | | | | 71.1 | |
| Expl. 5 | 0 | 0.87 | | | | 71.3 | |
| Expl. 6 | 0 | 0.3 | | | | 71.5 | |
| Com. Expl. 6 | 0 | 0.2 | | | | 71.8 | |
| Com. Expl. 7 | 1.96 | 1.96 | 5 | 100/0 | 2.21 | 66.8 | 350 |
| Com. Expl. 8 | 0.38 | 0.95 | | | | 68.1 | |
| Expl. 7 | 0.33 | 0.87 | | | | 68.9 | |
| Expl. 8 | 0.49 | 0.49 | | | | 68.6 | |
| Expl. 9 | 0.28 | 0.28 | | | | 68.6 | |
| Expl. 10 | 0.15 | 0.15 | | | | 69.1 | |
| Com. Expl. 9 | 0.1 | 0.1 | | | | 69.5 | |
| Com. Expl. 10 | 3.16 | 0 | 3 | 100/0 | 0.442 | 7.1 | 350 |
| Com. Expl. 11 | | | | | 1.105 | 25.1 | |
| Com. Expl. 12 | | | | | 1.66 | 42.3 | |
| Com. Expl. 13 | | | | | 2.21 | 65.5 | |
| Com. Expl. 14 | 0 | 4.99 | 8.3 | 100/0 | 0.442 | 8.2 | 400 |
| Com. Expl. 15 | | | | | 1.105 | 27.5 | |
| Com. Expl. 16 | | | | | 1.66 | 44.1 | |
| Com. Expl. 17 | | | | | 2.21 | 69.5 | |
| Com. Expl. 18 | 0 | 1.31 | 5.5 | 100/0 | 2.76 | 90.5 | 350 |
| Expl. 11 | | | | | | 90.9 | |
| Expl. 12 | | | | | | 90.4 | |
| Expl. 13 | | | | | | 90.5 | |
| Com. Expl. 19 | 0.28 | 0.28 | 1 | 100/0 | 1.66 | 41.2 | 300 |
| Expl. 14 | | | 2 | | | 42.3 | |
| Expl. 15 | | | 10.5 | | | 44.5 | |
| Expl. 16 | | | 15 | | | 43.5 | |
| Com. Expl. 20 | | | 20 | | | 35.2 | |
| Com. Expl. 21 | 0 | 0.3 | 6 | 100/0 | 2.76 | 75.2 | 150 |
| Expl. 17 | | | | | | 72.3 | 200 |
| Expl. 18 | | | | | | 71.8 | 400 |
| Expl. 19 | | | | | | 68.5 | 500 |
| Com. Expl. 22 | | | | | | 35.6 | 600 |

Table 1 (continued)

| | Characteristics of zinc-oxide based transparent conductive film | | | | | | |
|---|---|---|---|---|---|---|---|
| | Target composition | | Film thick-ness (nm) | Surface resist-ance (Ω/□) | Haze ratio (%) | Surface irregu-larity Ra (nm) | Remark |
| | Al/(Zn+Al) % by atom | Ga/(Zn+Ga) % by atom | | | | | |
| Com. Expl. 1 | 1.6 | 0 | 835 | 13.5 | 0.9 | 25.6 | |
| Com. Expl. 2 | 0.83 | 0 | 826 | 34.9 | 1.2 | 24.5 | |
| Expl. 1 | 0.66 | 0 | 835 | 43.6 | 8.4 | 35.2 | |
| Expl. 2 | 0.46 | 0 | 845 | 46.9 | 11.4 | 49.2 | |
| Expl. 3 | 0.32 | 0 | 832 | 63.2 | 12.5 | 56.1 | |
| Com. Expl. 3 | 0.21 | 0 | 846 | 189.2 | 13.6 | 58.9 | |
| Com. Expl. 4 | 0 | 3.49 | 796 | 15.4 | 0.9 | 25.4 | |
| Com. Expl. 5 | 0 | 2.65 | 795 | 13.5 | 2.6 | 30.5 | |
| Expl. 4 | 0 | 1.78 | 788 | 11.5 | 10.8 | 48.5 | |
| Expl. 5 | 0 | 0.89 | 784 | 18.9 | 11.4 | 50.1 | |
| Expl. 6 | 0 | 0.31 | 781 | 24.5 | 12.1 | 56.3 | |
| Com. Expl. 6 | 0 | 0.2 | 785 | 158.3 | 13.5 | 59.6 | |
| Com. Expl. 7 | 1.97 | 1.97 | 831 | 14.5 | 0.9 | 25.4 | |
| Com. Expl. 8 | 0.39 | 0.98 | 823 | 24.5 | 2.6 | 30.5 | |
| Expl. 7 | 0.33 | 0.87 | 835 | 29.3 | 8.5 | 37.8 | |
| Expl. 8 | 0.49 | 0.49 | 824 | 35.6 | 10.1 | 45.2 | |
| Expl. 9 | 0.29 | 0.29 | 832 | 41.5 | 11.1 | 46.8 | |
| Expl. 10 | 0.16 | 0.16 | 851 | 56.4 | 12.1 | 49.5 | |
| Com. Expl. 9 | 0.11 | 0.11 | 835 | 178.5 | 12.8 | 51.1 | |
| Com. Expl. 10 | 3.18 | 0 | 821 | 36.5 | 12.5 | 42.5 | Non-Patent Litera-ture 2 |
| Com. Expl. 11 | | | 835 | 16.5 | 2 | 33.7 | |
| Com. Expl. 12 | | | 815 | 12.5 | 0.9 | 24.5 | |
| Com. Expl. 13 | | | 823 | 11.1 | 0.7 | 21.5 | |
| Com. Expl. 14 | 0 | 5.03 | 795 | 90.4 | 0.9 | 24.4 | |
| Com. Expl. 15 | | | 791 | 36.9 | 0.4 | 19.1 | |
| Com. Expl. 16 | | | 786 | 22.5 | 0.2 | 18.5 | |
| Com. Expl. 17 | | | 785 | 18.5 | 0.2 | 18.1 | |
| Com. Expl. 18 | 0 | 1.35 | 830 | 16.2 | 5.2 | 33.3 | |
| Expl. 11 | | | 1010 | 12.9 | 8.6 | 37.1 | |
| Expl. 12 | | | 1350 | 10.9 | 11.6 | 49.5 | |
| Expl. 13 | | | 1620 | 7.7 | 13.2 | 55.2 | |
| Com. Expl. 19 | 0.29 | 0.29 | 1340 | 16.8 | 4.6 | 31.5 | |
| Expl. 14 | | | 1360 | 24.5 | 8.9 | 36.8 | |
| Expl. 15 | | | 1355 | 26.3 | 11.5 | 46.2 | |
| Expl. 16 | | | 1350 | 29.6 | 13.5 | 55.5 | |
| Com. Expl. 20 | | | 1352 | 75.2 | 16.8 | 65.3 | Weak film adhesion |
| Com. Expl. 21 | 0 | 0.31 | 1005 | 15.6 | 2.3 | 30.9 | |
| Expl. 17 | | | 1012 | 19.1 | 8.2 | 37.5 | |
| Expl. 18 | | | 1008 | 20.1 | 15.2 | 63.2 | |
| Expl. 19 | | | 1010 | 56.3 | 18.5 | 65.3 | |
| Com. Expl. 22 | | | 1005 | 78.5 | 19.5 | 69.8 | |

Table 2

| | Production condition of zinc oxide-based transparent conductive film | | | | | | Characteristics of zinc oxide-based transparent conductive film | | | Zinc oxide-based transparent conductive film formed at the surface of indium oxide-based transparent conductive film | Characteristics of laminated body | | | |
|---|---|---|---|---|---|---|---|---|---|---|---|---|---|---|
| | Target composition Sn/(In+Sn) % by atom | Gas pressure (Pa) | Ar/O2 (% by volume) | Input power density (W/cm2) | Substrate temperature (°C) | Aneal condition after film formation | Film composition Sn/(In+Sn) % by atom | Crystallinity | Film thickness (nm) | | Surface resistance (Ω/□) | Haze ratio (%) | Surface roughness Ra (nm) | Inclination of c-axis of zinc oxide-based transparent conductive film |
| Com. Expl. 23 | 9.29 | 0.6 | 94/6 | 1.660 | 300 | Non | 9.31 | Crystalline film | 150 | Com. Expl. 2 | 11.5 | 1.1 | 24.0 | 15 |
| Expl. 20 | | | | | | | | | | Expl. 1 | 13.4 | 8.1 | 33.2 | 13 |
| Expl. 21 | | | | | | | | | | Expl. 3 | 15.0 | 11.1 | 49.5 | 14 |
| Com. Expl. 24 | | | | | | | | | | Com. Expl. 3 | 110.2 | 12.1 | 54.6 | 13 |
| Expl. 22 | | | | | | | | | | Expl. 4 | 9.1 | 9.5 | 43.2 | 13 |
| Expl. 23 | | | | | | | | | | Expl. 6 | 15.0 | 11.1 | 49.9 | 14 |
| Com. Expl. 25 | | | | | | | | | | Com. Expl. 8 | 9.5 | 2.0 | 30.1 | 12 |
| Expl. 24 | | | | | | | | | | Expl. 7 | 10.5 | 8.1 | 35.4 | 13 |
| Expl. 25 | | | | | | | | | | Expl. 9 | 13.2 | 10.2 | 46.9 | 12 |
| Expl. 26 | | | | | | | | | | Expl. 10 | 14.8 | 10.9 | 46.5 | 13 |
| Com. Expl. 26 | | | | | | | | | | Com. Expl. 9 | 102.1 | 11.0 | 48.5 | 12 |
| Com. Expl. 27 | 9.29 | 0.6 | 94/6 | 1.660 | RT | 400°C, 30 min in vacuum | 9.31 | Crystalline film | 150 | Com. Expl. 2 | 12.2 | 1.2 | 23.5 | 5 |
| Expl. 27 | | | | | | | | | | Expl. 1 | 14.2 | 11.2 | 46.5 | 8 |
| Expl. 28 | | | | | | | | | | Expl. 3 | 15.8 | 14.1 | 55.8 | 6 |
| Com. Expl. 28 | | | | | | | | | | Com. Expl. 3 | 125.0 | 15.2 | 64.5 | 4 |
| Com. Expl. 29 | | | | | | 300°C, 30 min in vacuum | 9.32 | | | Com. Expl. 5 | 10.5 | 2.9 | 31.2 | 3 |
| Expl. 29 | | | | | | | | | | Expl. 4 | 9.8 | 13.2 | 53.1 | 3 |
| Expl. 30 | | | | | | | | | | Expl. 6 | 15.5 | 13.8 | 54.2 | 5 |
| Com. Expl. 30 | | | | | | | | | | Com. Expl. 6 | 95.2 | 15.2 | 63.3 | 4 |
| Expl. 31 | | | | | | 350°C, 30 min in vacuum | 9.31 | | | Expl. 7 | 11.0 | 9.6 | 42.1 | 1 |
| Expl. 32 | | | | | | | | | | Expl. 9 | 13.5 | 12.5 | 56.5 | 6 |
| Expl. 33 | | | | | | | | | | Expl. 10 | 15.0 | 14.2 | 58.2 | 2 |
| Com. Expl. 31 | 17.56 | 0.3 | 92/8 | 2.210 | RT | 200°C, 30 min in vacuum | 18.10 | Cryst.+Amor. | 45 | Expl. 17 | 19.0 | 5.2 | 24.0 | 8 |
| Expl. 34 | 14.95 | | | | | | 14.98 | Crystalline film | | | 20.5 | 9.2 | 37.1 | 6 |
| Expl. 35 | 9.29 | | | | | | 9.32 | | | | 15.2 | 9.5 | 37.8 | 5 |
| Expl. 36 | 4.62 | | | | | | 4.65 | | | | 14.5 | 8.9 | 37.5 | 4 |
| Expl. 37 | 0.20 | | | | | | 0.21 | | | | 15.2 | 9.2 | 37.0 | 1 |

Table 3

| Sample | Target composition Ti/(In+Ti) % by atom | Gas pressure (Pa) | Ar/O2 (% by volume) | Charge power density (W/cm2) | Substrate temperature (°C) | Aneal condition after film formation | Film composition Ti/(In+Ti) % by atom | Crystallinity | Film thickness (nm) | Zinc oxide-based transparent conductive film formed at the surface of indium oxide-based transparent conductive film | Surface resistance (Ω/□) | Haze ratio (%) | Surface roughness Ra (nm) | Inclination of c-axis of zinc oxide-based transparent conductive film |
|---|---|---|---|---|---|---|---|---|---|---|---|---|---|---|
| Com. Expl. 32 | 1.73 | 0.4 | 94/6 | 1660 | 300 | Non | 1.79 | Crystalline film | 200 | Com. Expl. 2 | 8.5 | 1.1 | 24.0 | 13 |
| Expl. 38 | | | | | | | | | | Expl. 1 | 9.1 | 8.2 | 33.1 | 11 |
| Expl. 39 | | | | | | | | | | Expl. 3 | 9.6 | 11.5 | 50.1 | 12 |
| Com. Expl. 33 | | | | | | | | | | Com. Expl. 3 | 78.5 | 12.1 | 54.6 | 14 |
| Expl. 40 | | | | | | | | | | Expl. 4 | 8.8 | 10.1 | 44.8 | 12 |
| Expl. 41 | | | | | | | | | | Expl. 6 | 13.5 | 10.8 | 45.2 | 13 |
| Com. Expl. 34 | | | | | | | | | | Com. Expl. 8 | 9.1 | 2.1 | 31.1 | 15 |
| Expl. 42 | | | | | | | | | | Expl. 7 | 9.1 | 8.2 | 35.2 | 12 |
| Expl. 43 | | | | | | | | | | Expl. 9 | 9.9 | 10.5 | 47.5 | 13 |
| Expl. 44 | | | | | | | | | | Expl. 10 | 10.5 | 11.2 | 46.5 | 11 |
| Com. Expl. 35 | | | | | | | | | | Com. Expl. 9 | 89.5 | 12.1 | 49.1 | 12 |
| Com. Expl. 36 | 1.73 | 0.4 | 94/6 | 1660 | RT | 400°C, 30 min in vacuum | 1.76 | Crystalline film | 200 | Com. Expl. 2 | 9.1 | 2.5 | 30.1 | 5 |
| Expl. 45 | | | | | | | | | | Expl. 1 | 9.8 | 15.6 | 63.2 | 6 |
| Expl. 46 | | | | | | | | | | Expl. 3 | 10.1 | 16.9 | 65.2 | 4 |
| Com. Expl. 37 | | | | | | | | | | Com. Expl. 3 | 79.5 | 18.2 | 65.2 | 3 |
| Com. Expl. 38 | | | | | | 300°C, 30 min in vacuum | 1.77 | | | Com. Expl. 5 | 9.8 | 3.2 | 31.6 | 1 |
| Expl. 47 | | | | | | | | | | Expl. 4 | 9.1 | 14.1 | 60.2 | 2 |
| Expl. 48 | | | | | | | | | | Expl. 6 | 14.2 | 15.1 | 63.1 | 3 |
| Com. Expl. 39 | | | | | | | | | | Com. Expl. 6 | 85.9 | 16.5 | 65.0 | 5 |
| Expl. 49 | | | | | | 350°C, 30 min in vacuum | 1.75 | | | Expl. 7 | 8.9 | 10.1 | 44.8 | 0 |
| Expl. 50 | | | | | | | | | | Expl. 9 | 10.5 | 15.2 | 64.2 | 3 |
| Expl. 51 | | | | | | | | | | Expl. 10 | 11.5 | 14.5 | 57.6 | 1 |
| Com. Expl. 40 | 7.25 | 0.3 | 93/7 | 2210 | RT | 300°C, 30 min in vacuum | 7.35 | Cryst+Amor. | 100 | Expl. 14 | 24.8 | 5.0 | 31.0 | 2 |
| Expl. 52 | 5.50 | | | | | | 5.58 | Crystalline film | | | 13.5 | 12.5 | 52.5 | 1 |
| Expl. 53 | 3.47 | | | | | | 3.49 | | | | 8.9 | 13.1 | 55.1 | 0 |
| Expl. 54 | 0.88 | | | | | | 0.91 | | | | 9.5 | 12.8 | 51.6 | 3 |
| Expl. 55 | 0.35 | | | | | | 0.37 | | | | 12.5 | 13.3 | 55.3 | 2 |

EP 2 407 575 B1

Table 4

| | Production condition of indium oxide-based transparent | | | | | | Characteristics of zinc oxide-based | | | Zinc oxide-based transparent conductive film formed at the surface of indium oxide-based transparent conductive film | Characteristics of laminated body | | | |
|---|---|---|---|---|---|---|---|---|---|---|---|---|---|---|
| | Target composition W/(In+W) % by atom | Gas pressure (Pa) | Ar/O2 (% by volume) | Charge power density (W/cm2) | Substrate temperature (°C) | Aneal condition after film formation | Film composition W/(In+W) % by atom | Crystallinity | Film thickness (nm) | | Surface resistance (Ω/□) | Haze ratio (%) | Surface roughness Ra (nm) | Inclination of c-axis of zinc oxide-based transparent conductive film |
| Com. Expl. 41 | 5.01 | | | | | 300°C, 30 min in vacuum | 5.05 | Cryst./amor. | | | 24.6 | 7.5 | 33.2 | 2 |
| Expl. 56 | 4.28 | | | | | | 4.28 | Crystalline film | | | 12.4 | 13.5 | 55.3 | 3 |
| Expl. 57 | 3.06 | 0.3 | 93/7 | 2.210 | RT | | 3.06 | | 180 | Expl. 6 | 10.2 | 14.5 | 60.2 | 2 |
| Expl. 58 | 1.00 | | | | | | 0.91 | | | | 8.9 | 15.1 | 64.2 | 2 |
| Expl. 59 | 0.30 | | | | | | 0.37 | | | | 12.8 | 17.8 | 62.5 | 2 |
| Com. Expl. 42 | 7.05 | | | | | 400°C, 30 min in vacuum | 7.08 | Cryst./amor. | | | 20.5 | 7.1 | 30.5 | 3 |
| Expl. 60 | 6.50 | | | | | | 6.56 | Crystalline film | | | 15.2 | 13.5 | 58.5 | 4 |
| Expl. 61 | 3.50 | 0.2 | 94/6 | 2.210 | RT | | 3.55 | | 300 | Expl. 2 | 11.2 | 12.8 | 56.5 | 6 |
| Expl. 62 | 0.65 | | | | | | 0.68 | | | | 9.3 | 13.8 | 58.6 | 1 |
| Expl. 63 | 0.25 | | | | | | 0.27 | | | | 10.6 | 14.5 | 61.5 | 9 |
| Com. Expl. 43 | 7.50 | | | | | 350°C, 30 min in vacuum | 7.58 | Cryst./amor. | | | 12.2 | 6.8 | 33.8 | 8 |
| Expl. 64 | 6.85 | | | | | | 6.91 | Crystalline film | | | 9.5 | 12.5 | 55.2 | 2 |
| Expl. 65 | 4.50 | 0.3 | 93/7 | 2.210 | RT | | 4.85 | | 180 | Expl. 11 | 8.5 | 13.2 | 56.8 | 6 |
| Expl. 66 | 2.56 | | | | | | 2.60 | | | | 9.1 | 14.1 | 58.6 | 4 |
| Expl. 67 | 0.25 | | | | | | 0.26 | | | | 10.1 | 13.8 | 56.8 | 5 |

The silicon-based thin film solar cell of the present invention adopts the transparent conductive film superior in hydrogen reduction resistance and also superior in optical confinement effect, and the transparent conductive film laminated body using the same, therefore it is a solar cell with high photoelectric conversion efficiency. The transparent conductive film having high conductivity and high transmittance in a visible light region has been utilized in an electrode or the like, for a solar cell or a liquid crystal display element, and other various light receiving elements, as well as a heat ray reflection film for an automotive window or construction use, an antistatic film, and a transparent heat generator for various anti-fogging for a refrigerator showcase and the like.

**Claims**

1. A transparent conductive film (II, 2) **characterized by** consisting of zinc oxide as a major component and at least one or more kinds of added metal elements selected from aluminum and gallium, whose content being within a range shown by the following expression (1) and having a surface roughness (Ra) of 35.0 nm to 70 nm and a surface resistance of more than 0 $\Omega/\square$ and equal to or lower than 65 $\Omega/\square$

$$-[Al] + 0.30 \leq [Ga] \leq -2.68 \times [Al] + 1.74 \text{ --- (1)}$$

(wherein [Al] represents aluminum content expressed as atomic ratio (%) of Al/(Zn+Al), while [Ga] represents gallium content expressed as atomic ratio (%) of Ga/(Zn+Ga)),
wherein said transparent conductive film (II, 2) is obtainable by a sputtering method, using an oxide sintered body target consisting of zinc oxide as a major component and at least one or more kinds of added metal elements selected from aluminum and gallium, wherein the film formation is performed in high speed, by setting a direct current input power density of equal to or higher than 1.66 W/cm$^2$ to the aforesaid oxide sintered body target, under condition of a sputtering gas pressure of 2.0 to 15.0 Pa, and a substrate temperature of 200 to 500 °C.

2. The transparent conductive film(II, 2) according to claim 1, **characterized in that** the haze ratio is equal to or higher than 8 %.

3. The transparent conductive film (II, 2) according to claim 1 or 2, **characterized in that** the haze ratio is equal to or higher than 10 %.

4. The transparent conductive film (II, 2) according to any one of claims 1 to 3, **characterized in that** the haze ratio is equal to or higher than 16 %.

5. The transparent conductive film (II, 2) according to claim 1, **characterized in that** the surface resistance is equal to or lower than 20 $\Omega/\square$.

6. The transparent conductive film (II, 2) according to claim 1 or 5, **characterized in that** the surface resistance is equal to or lower than 15 $\Omega/\square$.

7. A method for producing the transparent conductive film (II, 2) according to any one of claims 1 to 6 forming a zinc oxide-based transparent conductive film (II, 2) on a substrate, by a sputtering method, using an oxide sintered body target consisting of zinc oxide as a major component and at least one or more kinds of added metal elements selected from aluminum and gallium, **characterized by** performing film formation in high speed, by setting a direct current input power density of equal to or higher than 1.66 W/cm$^2$ to the aforesaid oxide sintered body target, under condition of a sputtering gas pressure of 2.0 to 15.0 Pa, and a substrate temperature of 200 to 500 °C.

8. A transparent conductive film laminated body, **characterized in that** the zinc oxide-based transparent conductive film (II, 2) according to any one of claims 1 to 6 was formed on an indium oxide-based transparent conductive film (I) formed on the substrate.

9. The transparent conductive film laminated body according to claim 8, **characterized in that** the transparent conductive film (II, 2) is a crystalline film comprising a hexagonal crystalline phase.

10. The transparent conductive film laminated body according to claim 9, **characterized in that** the hexagonal crystalline phase has approximately c-axis orientation, and a c-axis inclination angle is equal to or smaller than 10 degree, relative to a vertical direction of a substrate surface.

11. The transparent conductive film laminated body according to claim 8, **characterized in that** the indium oxide-based transparent conductive film (I) is a crystalline film consisting of indium oxide as a major component and at least one or more kinds of metal elements selected from Sn, Ti, W, Mo, and Zr.

12. The transparent conductive film laminated body according to claim 8 or 11, **characterized in that** the indium oxide-based transparent conductive film (I) consists of indium oxide as a major component and Sn, whose content ratio is equal to or lower than 15 % by atom, as atomic ratio of Sn/(In+Sn).

13. The transparent conductive film laminated body according to claim 8 or 11, **characterized in that** the indium oxide-based transparent conductive film (I) consists of indium oxide as a major component and Ti, whose content ratio is equal to or lower than 5.5 % by atom, as atomic ratio of Ti/(In+Ti).

14. The transparent conductive film laminated body according to claim 8 or 11, **characterized in that** the indium oxide-based transparent conductive film (I) consists of indium oxide as a major component and W, whose content ratio is equal to or lower than 4.3 % by atom, as atomic ratio of W/(In+W).

15. The transparent conductive film laminated body according to claim 8 or 11, **characterized in that** the indium oxide-based transparent conductive film (I) consists of indium oxide as a major component and Zr, whose content ratio is equal to or lower than 6.5 % by atom, as atomic ratio of Zr/(In+Zr).

16. The transparent conductive film laminated body according to claim 8 or 11, **characterized in that** the indium oxide-based transparent conductive film (I) consists of indium oxide as a major component and Mo, whose content ratio is equal to or lower than 6.7 % by atom, as atomic ratio of Mo/(In+Mo).

17. The transparent conductive film laminated body according to any one of claims 8 to 16, **characterized in that** the surface resistance is equal to or lower than 20 $\Omega/\square$.

18. The transparent conductive film laminated body according to any one of claims 8 to 17, **characterized in that** the haze ratio is equal to or higher than 12 %.

19. A method for producing the transparent conductive film laminated body according to any one of claims 8 to 18, **characterized by** firstly forming a crystalline film of the indium oxide-based transparent conductive film (I) on a substrate, by a sputtering method, using an oxide sintered body target consisting of indium oxide as a major component containing at least one or more kinds of metal elements selected from Sn, Ti, W, Mo, and Zr, and then forming the zinc oxide-based transparent conductive film (II, 2) on the indium oxide-based transparent conductive film (I), by switching to an oxide sintered body target consisting of zinc oxide as a major component and at least one or more kinds of added metal elements selected from aluminum and gallium.

20. The method for producing the transparent conductive film laminated body according to claim 19, **characterized in that** the indium oxide-based transparent conductive film (I) is formed as an amorphous film, under condition of a substrate temperature of equal to or lower than 100°C and a sputtering gas pressure of 0.1 to 1.0 Pa, and subsequently crystallized by heat treatment at 200 to 400°C.

21. The method for producing the transparent conductive film laminated body according to claim 19, **characterized in that** the indium oxide-based transparent conductive film (I) is formed as a crystalline film, under condition of a substrate temperature of 200 to 400°C and a sputtering gas pressure of 0.1 to 1.0 Pa.

22. A silicon-based thin film solar cell, wherein the transparent conductive film (II, 2) according to any one of claims 1 to 6, or the transparent conductive film laminated body according to any one of claims 8 to 17 is formed on a translucent substrate (1), and at least one kind of a unit selected from one conducting type semiconductor layer unit, a photoelectric conversion layer unit, and other conducting type semiconductor layer unit, is arranged on the aforesaid transparent conductive film (II, 2) or transparent conductive film laminated body, and a back surface electrode layer (5) is arranged on said unit.

**Patentansprüche**

1. Transparenter leitender Film (II, 2), **dadurch gekennzeichnet, dass** er aus Zinkoxid als eine Hauptkomponente und mindestens einer Art oder mehreren Arten von zugesetzten Metallelementen besteht, die aus Aluminium und Gallium ausgewählt sind, deren Gehalt innerhalb eines Bereichs liegt, der durch den folgenden Ausdruck (1) dargestellt ist, und der eine Oberflächenrauheit (Ra) von 35,0 nm bis 70 nm und einen Oberflächenwiderstand von mehr als 0 Ω/□ und gleich oder weniger als 65 Ω/□ aufweist,

$$-[Al] + 0,30 \leq [Ga] \leq -2,68 \times [Al] + 1,74 \;\text{---}\; (1)$$

(worin [Al] den Aluminiumgehalt, angegeben als Atomverhältnis (%) von Al/(Zn + Al), darstellt, während [Ga] den Galliumgehalt, angegeben als Atomverhältnis (%) von Ga/(Zn + Ga), darstellt),
wobei der transparente leitende Film (II, 2) durch ein Sputterverfahren unter Verwendung eines Oxid-Sinterkörpertargets erhältlich ist, das aus Zinkoxid als eine Hauptkomponente und mindestens einer Art oder mehreren Arten von zugesetzten Metallelementen besteht, die aus Aluminium und Gallium ausgewählt sind, wobei die Filmbildung durch Einstellen einer Gleichstrom-Eingangsleistungsdichte von gleich oder höher als 1,66 W/cm$^2$ bezüglich des Oxid-Sinterkörpertargets unter der Bedingung eines Sputtergasdrucks von 2,0 bis 15,0 Pa und einer Substrattemperatur von 200 bis 500 °C mit einer hohen Geschwindigkeit durchgeführt wird.

2. Transparenter leitender Film (II, 2) nach Anspruch 1, **dadurch gekennzeichnet, dass** der Trübungsanteil gleich oder höher als 8 % ist.

3. Transparenter leitender Film (II, 2) nach Anspruch 1 oder 2, **dadurch gekennzeichnet, dass** der Trübungsanteil gleich oder höher als 10 % ist.

4. Transparenter leitender Film (II, 2) nach einem der Ansprüche 1 bis 3, **dadurch gekennzeichnet, dass** der Trübungsanteil gleich oder höher als 16 % ist.

5. Transparenter leitender Film (II, 2) nach Anspruch 1, **dadurch gekennzeichnet, dass** der Oberflächenwiderstand gleich oder niedriger als 20 Ω/□ ist.

6. Transparenter leitender Film (II, 2) nach Anspruch 1 oder 5, **dadurch gekennzeichnet, dass** der Oberflächenwiderstand gleich oder niedriger als 15 Ω/□ ist.

7. Verfahren zur Herstellung des transparenten leitenden Films (II, 2) nach einem der Ansprüche 1 bis 6, bei dem ein transparenter leitender Film auf Zinkoxidbasis (II, 2) auf einem Substrat durch ein Sputterverfahren unter Verwendung eines Oxid-Sinterkörpertargets gebildet wird, das aus Zinkoxid als eine Hauptkomponente und mindestens einer Art oder mehreren Arten von zugesetzten Metallelementen besteht, die aus Aluminium und Gallium ausgewählt sind, **dadurch gekennzeichnet, dass** eine Filmbildung durch Einstellen einer Gleichstrom-Eingangsleistungsdichte von gleich oder höher als 1,66 W/cm$^2$ bezüglich des Oxid-Sinterkörpertargets unter der Bedingung eines Sputtergasdrucks von 2,0 bis 15,0 Pa und einer Substrattemperatur von 200 bis 500 °C mit einer hohen Geschwindigkeit durchgeführt wird.

8. Laminierter Körper mit einem transparenten leitenden Film, **dadurch gekennzeichnet, dass** der transparente leitende Film auf Zinkoxidbasis (II, 2) nach einem der Ansprüche 1 bis 6 auf einem transparenten leitenden Film auf Indiumoxidbasis (I) ausgebildet worden ist, der auf dem Substrat ausgebildet ist.

9. Laminierter Körper mit einem transparenten leitenden Film nach Anspruch 8, **dadurch gekennzeichnet, dass** der transparente leitende Film (II, 2) ein kristalliner Film ist, der eine hexagonale kristalline Phase umfasst.

10. Laminierter Körper mit einem transparenten leitenden Film nach Anspruch 9, **dadurch gekennzeichnet, dass** die hexagonale kristalline Phase etwa eine c-Achsenorientierung aufweist und dass der c-Achsenneigungswinkel bezogen auf die vertikale Richtung einer Substratoberfläche gleich oder kleiner als 10 Grad ist.

11. Laminierter Körper mit einem transparenten leitenden Film nach Anspruch 8, **dadurch gekennzeichnet, dass** der transparente leitende Film auf Indiumoxidbasis (I) ein kristalliner Film ist, der aus Indiumoxid als eine Hauptkomponente und mindestens einer Art oder mehreren Arten von Metallelementen besteht, die aus Sn, Ti, W, Mo und Zr ausgewählt sind.

**12.** Laminierter Körper mit einem transparenten leitenden Film nach Anspruch 8 oder 11, **dadurch gekennzeichnet, dass** der transparente leitende Film auf Indium-oxidbasis (I) aus Indiumoxid als eine Hauptkomponente und Sn besteht, dessen Gehaltverhältnis als Atomverhältnis von Sn/(In + Sn) gleich oder niedriger als 15 Atom-% ist.

**13.** Laminierter Körper mit einem transparenten leitenden Film nach Anspruch 8 oder 11, **dadurch gekennzeichnet, dass** der transparente leitende Film auf Indium-oxidbasis (I) aus Indiumoxid als eine Hauptkomponente und Ti besteht, dessen Gehaltverhältnis als Atomverhältnis von Ti/(In + Ti) gleich oder niedriger als 5,5 Atom-% ist.

**14.** Laminierter Körper mit einem transparenten leitenden Film nach Anspruch 8 oder 11, **dadurch gekennzeichnet, dass** der transparente leitende Film auf Indium-oxidbasis (I) aus Indiumoxid als eine Hauptkomponente und W besteht, dessen Gehaltverhältnis als Atomverhältnis von W/(In + W) gleich oder niedriger als 4,3 Atom-% ist.

**15.** Laminierter Körper mit einem transparenten leitenden Film nach Anspruch 8 oder 11, **dadurch gekennzeichnet, dass** der transparente leitende Film auf Indium-oxidbasis (I) aus Indiumoxid als eine Hauptkomponente und Zr besteht, dessen Gehaltverhältnis als Atomverhältnis von Zr/(In + Zr) gleich oder niedriger als 6,5 Atom-% ist.

**16.** Laminierter Körper mit einem transparenten leitenden Film nach Anspruch 8 oder 11, **dadurch gekennzeichnet, dass** der transparente leitende Film auf Indium-oxidbasis (I) aus Indiumoxid als eine Hauptkomponente und Mo besteht, dessen Gehaltverhältnis als Atomverhältnis von Mo/(In + Mo) gleich oder niedriger als 6,7 Atom-% ist.

**17.** Laminierter Körper mit einem transparenten leitenden Film nach einem der Ansprüche 8 bis 16, **dadurch gekennzeichnet, dass** der Oberflächenwiderstand gleich oder niedriger als 20 Ω/□ ist.

**18.** Laminierter Körper mit einem transparenten leitenden Film nach einem der Ansprüche 8 bis 17, **dadurch gekennzeichnet, dass** der Trübungsanteil gleich oder höher als 12 % ist.

**19.** Verfahren zur Herstellung des laminierten Körpers mit einem transparenten leitenden Film nach einem der Ansprüche 8 bis 18, **dadurch gekennzeichnet, dass** zuerst ein kristalliner Film aus dem transparenten leitenden Film auf Indium-oxidbasis (I) auf einem Substrat durch ein Sputterverfahren unter Verwendung eines Oxid-Sinterkörpertargets gebildet wird, das aus Indiumoxid als eine Hauptkomponente besteht und mindestens eine Art oder mehrere Arten von Metallelementen enthält, die aus Sn, Ti, W, Mo und Zr ausgewählt sind, und dann der transparente leitende Film auf Zinkoxidbasis (II, 2) durch Wechseln zu einem Oxid-Sinterkörpertarget, das aus Zinkoxid als eine Hauptkomponente und mindestens einer Art oder mehreren Arten von zugesetzten Metallelementen besteht, die aus Aluminium und Gallium ausgewählt sind, auf dem transparenten leitenden Film auf Indiumoxidbasis (I) gebildet wird.

**20.** Verfahren zur Herstellung des laminierten Körpers mit einem transparenten leitenden Film nach Anspruch 19, **dadurch gekennzeichnet, dass** der transparente leitende Film auf Indiumoxidbasis (I) unter Bedingungen einer Substrattemperatur von gleich oder niedriger als 100 °C und eines Sputtergasdrucks von 0,1 bis 1,0 Pa als amorpher Film ausgebildet wird und anschließend durch eine Wärmebehandlung bei 200 bis 400 °C kristallisiert wird.

**21.** Verfahren zur Herstellung des laminierten Körpers mit einem transparenten leitenden Film nach Anspruch 19, **dadurch gekennzeichnet, dass** der transparente leitende Film auf Indiumoxidbasis (I) unter Bedingungen einer Substrattemperatur von 200 bis 400 °C und eines Sputtergasdrucks von 0,1 bis 1,0 Pa als kristalliner Film ausgebildet wird.

**22.** Dünnfilmsolarzelle auf Siliziumbasis, bei welcher der transparente leitende Film (II, 2) nach einem der Ansprüche 1 bis 6 oder der laminierte Körper mit einem transparenten leitenden Film nach einem der Ansprüche 8 bis 17 auf einem lichtdurchlässigen Substrat (1) ausgebildet ist und mindestens eine Art einer Einheit, ausgewählt aus einer Halbleiterschichteinheit des leitenden Typs, einer photoelektrischen Konversionsschichteinheit und einer anderen Halbleiterschichteinheit des leitenden Typs, auf dem vorstehend genannten transparenten leitenden Film (II, 2) oder laminierten Körper mit einem transparenten leitenden Film angeordnet ist und auf der Einheit eine Rückflächenelektrodenschicht (5) angeordnet ist.

**Revendications**

1.  Film conducteur transparent (II, 2) **caractérisé en ce qu'**il consiste en de l'oxyde de zinc comme composant majeur et au moins un ou plusieurs types d'éléments métalliques ajoutés choisis parmi l'aluminium et le gallium, dont la teneur se situe dans l'intervalle donné par l'expression (1) suivante et ayant une rugosité de surface située dans l'intervalle allant de 35,0 nm à 70 nm et une résistance de surface supérieure à 0 Ω/□ et égale ou inférieure à 65 Ω/□

$$-[Al] + 0.30 \leq [Ga] \leq -2.68 \times [Al] + 1.74 \text{ --- (1)}$$

(où [Al] représente la teneur en aluminium exprimée sous forme du rapport atomique (%) de Al/(Zn+Al), alors que [Ga] représente la teneur en gallium exprimée sous forme du rapport atomique (%) de Ga/(Zn+Ga)),
où ledit film conducteur transparent (II, 2) peut être obtenu par un procédé de pulvérisation, en utilisant une cible corps d'oxyde fritté consistant en l'oxyde de zinc en tant que composant majeur et au moins un ou plusieurs types d'éléments métalliques ajoutés choisis parmi l'aluminium et le gallium, où la formation du film est réalisée à haute vitesse, par réglage d'une densité de puissance d'entrée de courant continu égale ou supérieure à 1,66 W/cm$^2$ sur la cible corps d'oxyde fritté, dans des conditions de pression du gaz de pulvérisation de 2,0 à 15,0 Pa, et une température de substrat de 200 à 500°C.

2.  Film conducteur transparent (II, 2) selon la revendication 1, **caractérisé en ce que** le rapport de voile est égal ou supérieur à 8%.

3.  Film conducteur transparent (II, 2) selon la revendication 1 ou 2, **caractérisé en ce que** le rapport de voile est égal ou supérieur à 10%.

4.  Film conducteur transparent (II, 2) selon l'une quelconque des revendications 1 à 3, **caractérisé en ce que** le rapport de voile est égal ou supérieur à 16%.

5.  Film conducteur transparent (II, 2) selon la revendication 1, **caractérisé en ce que** la résistance de surface est égale ou inférieure à 20 Ω/□.

6.  Film conducteur transparent (II, 2) selon la revendication 1 ou 5, **caractérisé en ce que** la résistance de surface est égale ou inférieure à 15 Ω/□.

7.  Procédé de production du film conducteur transparent (II, 2) selon l'une quelconque des revendications 1 à 6, par formation d'un film conducteur transparent (II, 2) à base d'oxyde de zinc sur un substrat, par un procédé de pulvérisation en utilisant une cible corps d'oxyde fritté consistant en l'oxyde de zinc en tant que composant majeur et au moins un ou plusieurs types d'éléments métalliques ajoutés choisis parmi l'aluminium et le gallium, **caractérisé en ce que** la formation du film est réalisée à haute vitesse, par réglage d'une densité de puissance d'entrée de courant continu égale ou supérieure à 1,66 W/cm$^2$ sur la cible corps d'oxyde fritté, dans des conditions de pression du gaz de pulvérisation de 2,0 à 15,0 Pa, et une température de substrat de 200 à 500°C,

8.  Corps stratifié à film conducteur transparent, **caractérisé en ce que** le film conducteur transparent (II, 2) à base d'oxyde de zinc selon l'une quelconque des revendications 1 à 6 est formé sur un film conducteur transparent (I) à base d'oxyde d'indium formé sur le substrat.

9.  Corps stratifié à film conducteur transparent selon la revendication 8, **caractérisé en ce que** le film conducteur transparent (II, 2) est un film cristallin comprenant une phase cristalline hexagonale.

10. Corps stratifié à film conducteur transparent selon la revendication 9, **caractérisé en ce que** la phase cristalline hexagonale a une orientation environ d'axe c et que l'angle d'inclinaison de l'axe c est égal ou inférieur à 10°, par rapport à la direction verticale d'une surface du substrat.

11. Corps stratifié à film conducteur transparent selon la revendication 8, **caractérisé en ce que** le film conducteur transparent (I) à base d'oxyde d'indium est un film cristallin consistant en l'oxyde d'indium comme composant majeur et au moins un ou plusieurs types d'éléments métalliques choisis parmi Sn, Ti, W, Mo et Zr.

**12.** Corps stratifié à film conducteur transparent selon la revendication 8 ou 11, **caractérisé en ce que** le film conducteur transparent (I) à base d'oxyde d'indium consiste en l'oxyde d'indium en tant que composant majeur et de Sn, dont le rapport de teneur est égal ou inférieur à 15% en atomes, en tant que rapport atomique Sn/(In+Sn).

**13.** Corps stratifié à film conducteur transparent selon la revendication 8 ou 11, **caractérisé en ce que** le film conducteur transparent (I) à base d'oxyde d'indium consiste en l'oxyde d'indium en tant que composant majeur et de Ti, dont le rapport de teneur est égal ou inférieur à 5,5% en atomes, en tant que rapport atomique Ti/(In+Ti).

**14.** Corps stratifié à film conducteur transparent selon la revendication 8 ou 11, **caractérisé en ce que** le film conducteur transparent (I) à base d'oxyde d'indium consiste en l'oxyde d'indium en tant que composant majeur et de W, dont le rapport de teneur est égal ou inférieur à 4,3% en atomes, en tant que rapport atomique W/(In+W).

**15.** Corps stratifié à film conducteur transparent selon la revendication 8 ou 11, **caractérisé en ce que** le film conducteur transparent (I) à base d'oxyde d'indium consiste en l'oxyde d'indium en tant que composant majeur et de Zr, dont le rapport de teneur est égal ou inférieur à 6,5% en atomes, en tant que rapport atomique Zr/(In+Zr).

**16.** Corps stratifié à film conducteur transparent selon la revendication 8 ou 11, **caractérisé en ce que** le film conducteur transparent (I) à base d'oxyde d'indium consiste en l'oxyde d'indium en tant que composant majeur et de Mo, dont le rapport de teneur est égal ou inférieur à 6,7% en atomes, en tant que rapport atomique Mo/(In+Mo).

**17.** Corps stratifié à film conducteur transparent selon l'une quelconque des revendications 8 à 16, **caractérisé en ce que** la résistance de surface est égale ou inférieure à 20 Ω/□.

**18.** Corps stratifié à film conducteur transparent selon l'une quelconque des revendications 8 à 17, **caractérisé en ce que** le rapport de voile est égal ou supérieur à 12%.

**19.** Procédé de production du corps stratifié à film conducteur transparent selon l'une quelconque des revendications 8 à 18, **caractérisé en ce que** l'on forme d'abord, un film cristallin du film conducteur transparent (I) à base d'oxyde d'indium sur un substrat, par un procédé de pulvérisation en utilisant une cible corps d'oxyde fritté consistant en l'oxyde d'indium en tant que composant majeur contenant au moins un ou plusieurs types d'éléments métalliques choisis parmi Sn, Ti, W, Mo et Zr, puis la formation du film conducteur transparent (II, 2) à base d'oxyde de zinc sur le film conducteur transparent (I) à base d'oxyde d'indium, en changeant pour une cible corps d'oxyde fritté consistant en l'oxyde de zinc comme composant majeur et au moins un ou plusieurs types d'éléments métalliques ajoutés choisis parmi l'aluminium et le gallium.

**20.** Procédé de production du corps stratifié à film conducteur transparent selon la revendication 19, **caractérisé en ce que** le film conducteur transparent (I) à base d'oxyde d'indium est formé comme un film amorphe, dans des conditions de température de substrat égale ou inférieure à 100°C, et de pression du gaz de pulvérisation de 0,1 à 1,0 Pa, puis cristallisé par un traitement thermique de 200 à 400°C.

**21.** Procédé de production du corps stratifié à film conducteur transparent selon la revendication 19, **caractérisé en ce que** le film conducteur transparent (I) à base d'oxyde d'indium est formé comme un film cristallin, dans des conditions de température de substrat allant de 200 à 400°C, et de pression du gaz de pulvérisation de 0,1 à 1,0 Pa.

**22.** Cellule solaire à film mince à base de silicium, où le film conducteur transparent (II, 2) selon l'une quelconque des revendications 1 à 6, ou le corps stratifié à film conducteur transparent selon l'une quelconque des revendications 8 à 17 est formé sur un substrat translucide (1), et au moins un type d'une unité choisie parmi une unité de couche semi-conductrice de type conductrice, une unité de couche de conversion photoélectrique et une autre unité de couche semi-conductrice de type conductrice, est agencé sur le film conducteur transparent (II, 2) ou le corps stratifié à film conducteur transparent, et une couche d'électrode de surface arrière (5) est agencée sur ladite unité.

Figure 1

5 Back surface electrode

3 Amorphous photoelectric conversion unit

5m Back surface reflective electrode layer

5t Back surface transparent electrode layer

3n Amorphous n-type silicon layer

3i Non-dope amorphous i-type silicon photoelectric conversion layer

3p Amorphous p-type silicon layer

2 surface transparent electrode layer

1 Translucent substrate

Figure 2

5 Back surface electrode

4 Crystalline photoelectric conversion unit

3 Amorphous photoelectric conversion unit

5m Back surface reflective electrode layer

5t Back surface transparent electrode layer

4n Crystalline n-type silicon layer

4i Non-dope crystalline i-type silicon photoelectric conversion layer

4p Crystalline p-type silicon layer

3n Amorphous n-type silicon layer

3i Non-dope amorphous i-type silicon photoelectric conversion layer

3p Amorphous p-type silicon layer

2 surface transparent electrode layer

1 Translucent substrate

Figure 3

Figure 4

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- WO 62122011 A
- WO 10306367 A
- WO 2008110911 A
- WO 2008062685 A1
- JP 2003115599 A
- JP 2002222972 A
- WO 2009084527 A1

### Non-patent literature cited in the description

- **K. SATO et al.** Hydrogen Plasma Treatment of ZnO-Coated TCO Films. *Proc. of 23th IEEE Photovoltaic Specialists Conference,* 1993, 855-859
- **T. MINAMI.** Large-Area Milkey Transparent Conducting Al-Doped ZnO Films Prepared by Magnetron Sputtering. *Japanese Journal of Applied Physics,* 1992, L1106-1109
- **J. MULLER.** *Thin Solid Films,* 2001, vol. 392, 327
- **J. F. CHANG et al.** *Applied Surface Science,* 2001, vol. 183, 18-25
- **T. MINAMI et al.** *Japanese Journal of Applied Physics,* 1992, L257-L260
- **J. MULLER et al.** *Thin Solid Films,* 2001, vol. 392, 327-333